(19) Europäisches Patentamt
European Patent Office
Office européen des brevets

(11) EP 3 429 847 B1

(12) EUROPEAN PATENT SPECIFICATION

(45) Date of publication and mention of the grant of the patent:
**18.08.2021 Bulletin 2021/33**

(21) Application number: **17701907.2**

(22) Date of filing: **03.02.2017**

(51) Int Cl.:
***B41C 1/10*** *(2006.01)*
***B41N 3/08*** *(2006.01)*
***G03F 7/32*** *(2006.01)*
***B41N 3/00*** *(2006.01)*
***G03F 7/30*** *(2006.01)*

(86) International application number:
**PCT/EP2017/052416**

(87) International publication number:
**WO 2017/157576 (21.09.2017 Gazette 2017/38)**

# (54) METHOD FOR PROCESSING A LITHOGRAPHIC PRINTING PLATE

VERFAHREN ZUR VERARBEITUNG EINER LITHOGRAFIEDRUCKPLATTE

PROCÉDÉ DE TRAITEMENT D'UNE PLAQUE D'IMPRESSION LITHOGRAPHIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:
**16.03.2016 EP 16160576**
**16.03.2016 EP 16160591**
**16.03.2016 EP 16160616**
**16.03.2016 EP 16160627**
**10.05.2016 EP 16168969**

(43) Date of publication of application:
**23.01.2019 Bulletin 2019/04**

(73) Proprietor: **AGFA NV**
**2640 Mortsel (BE)**

(72) Inventors:
- **MORIAME, Philippe**
**2640 Mortsel (BE)**
- **BOGUNOVIC, Iris**
**2640 Mortsel (BE)**

(74) Representative: **Vanderstede, Els**
**AGFA NV**
**Intellectual Property Department**
**Septestraat 27**
**2640 Mortsel (BE)**

(56) References cited:
**EP-A2- 1 260 866**
**EP-A2- 1 696 274**
**WO-A1-2007/057347**
**JP-A- S62 143 055**

Remarks:
The file contains technical information submitted after the application was filed and not included in this specification

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

FIELD OF THE INVENTION

The present invention relates to a method for processing lithographic printing plates with a reduced consumption of processing liquids.

BACKGROUND OF THE INVENTION

Lithographic printing typically involves the use of a so-called printing master such as a printing plate which is mounted on a cylinder of a rotary printing press. The master carries a lithographic image on its surface and a print is obtained by applying ink to said image and then transferring the ink from the master onto a receiver material, which is typically paper. In conventional lithographic printing, ink as well as an aqueous fountain solution (also called dampening liquid) are supplied to the lithographic image which consists of oleophilic (or hydrophobic, i.e. ink-accepting, water-repelling) areas as well as hydrophilic (or oleophobic, i.e. water-accepting, ink-repelling) areas. These areas can also be referred to as printing and non-printing areas respectively or as image and non-image areas respectively. In so-called driographic printing, the lithographic image consists of ink-accepting and ink-abhesive (ink-repelling) areas and during driographic printing, only ink is supplied to the master.

Lithographic printing masters are generally obtained by the image-wise exposure and processing of a printing plate precursor (referred to hereafter as "plate material" or briefly as "plate"), which contains a heat- or light-sensitive coating on a substrate. The coating of the plate material is exposed image-wise to heat or light, typically by means of a digitally modulated exposure device such as a laser, which triggers a (physico-)chemical process, such as ablation, polymerization, insolubilization by cross-linking of a polymer or by particle coagulation of a thermoplastic polymer latex, solubilization by the destruction of intermolecular interactions or by increasing the penetrability of a development barrier layer. Although some plate materials are capable of producing a lithographic image immediately after exposure, the most popular plate materials require wet processing with a developer since the exposure produces a difference of solubility or of rate of dissolution in a developer between the exposed and the non-exposed areas of the coating. In positive working plate materials, the exposed areas of the coating dissolve in the developer while the non-exposed areas remain resistant to the developer. In negative working plate materials, the non-exposed areas of the coating dissolve in the developer while the exposed areas remain resistant to the developer. Most plate materials contain a hydrophobic coating on a hydrophilic substrate, so that the areas which remain resistant to the developer define the ink-accepting, printing areas of the plate while the hydrophilic substrate is revealed by the dissolution of the coating in the developer at the non-printing areas.

Conventionally, a plate material is developed by immersing it in, or spraying it with a developer as it passes through the processing apparatus. Typically the material is also subjected to mechanical rubbing with e.g. one or more rotating brushes or specified roller(s) - after a while or after being treated with the developer. After development, the plate is typically rinsed with water to remove any remaining developer and then gummed, which is sometimes also called finished or desensitized. Gumming involves the protection of the coating on the lithographic image, especially the non-printing areas, to avoid contamination or oxidation of the aluminum substrate. Gum solution can be applied by immersion, by spraying or by jetting as disclosed for example in EP 1 524 113.

During processing the rinse solution may become loaded with components of the development section due to carry over. The increasing amount of dissolved material in the rinse solution may result in a pH increase of said solution leading to a risk of so-called "over development" of the plate material. In addition, also the finishing solution may become contaminated due to carry over from the contaminated rinse section which may result in poor lithographic properties of the printing plates due to over development and/or a reduced gumming capacity i.e. a reduced ability to protect the plate material against oxidation and finger prints. In the art, in order to solve these contamination problems during processing, the water used during the rinsing step is abundantly replenished, for example 250ml to 500ml of fresh water per square meter corresponding to a yearly fresh water consumption of 5.000 l to 10.000 l for a plate production volume of about 20.000 $m^2$. From an ecological point of view however, such huge consumption of rinse water is unfavourable.

EP1696274 discloses a method for automatic development of photosensitive lithographic printing plate precursors.

Indeed, an important trend in lithographic platemaking is related to ecology and sustainability. Systems and methods which enable a low consumption of processing liquids such as developer, rinse water and gum solution, or which allow processing with aqueous developers comprising no hazardous chemicals and/or which have a pH close to 7 (neutral developer), have attracted a lot of attention in the marketplace. It remains therefore a challenge to provide sustainable processing systems which consume low amounts of processing liquids during the production of high quality printing plates.

## SUMMARY OF THE INVENTION

It is an object of the present invention to provide a method for processing lithographic printing plate materials with an alkaline developer which enables to reduce the consumption of rinse water, and/or to reduce the amount of waste liquids generated during processing, and/or to avoid or decrease contamination of the gum solutions during the processing step.

These object(s) are realised by the method defined in independent claim 1, with preferred embodiments defined in the dependent claims 2-14. The invention has the specific feature that the printing plate material is developed with an alkaline development solution, followed by treatment with an aqueous solution which contains a buffer whereby the pH change of said aqueous solution before and after said treatment is limited. This treatment is to rinse and/or neutralise the plate, i.e. the removal of any developer from the surface of the plate, and to ensure good clean-out of the image, if not already obtained in the development unit.

The method of the current invention highly contributes to the reduction of waste liquids because, as the pH of the buffered aqueous solution remains stable, the treatment with the buffered aqueous solution after treating with the alkaline solution allows for a substantially lower water consumption. Contrary to conventional systems, which consume typically between 5.000 l and 10.000 l of rinse water for a plate production volume of 20.000 $m^2$ plates per year, the method of the current invention, typically requires for the same production volume less than 5.000 l of aqueous rinse solution per year.

In summary, the method of the present invention provides the major advantage of consuming low amounts of processing liquids - such as rinse liquid and/or gum/finishing liquid - and thus generating only small amounts of waste liquids. Therefore, the current invention is not only cost-efficient, but is also favorable from an environmental point of view.

Further objects of the invention will become apparent from the description hereinafter.

## BRIEF DESCRIPTION OF THE DRAWINGS

FIG. 1 is a schematic representation of a preferred embodiment of the development unit of the apparatus of the invention, shown as it is filled with developer solution.

FIG. 2a is a more detailed representation of the development cavity viewed along the processing direction wherein the cover plate (7) and the bottom plate are provided with protruding elements (20).

FIG. 2b is a more detailed representation of the development cavity viewed along the direction which is perpendicular to the processing direction.

FIG. 2c is a more detailed representation of the development cavity viewed along the processing direction wherein the cover plate (7) is provided with protruding elements (20).

FIG. 3a and 3b are schematic representations of protruding elements (ribs) provided on the cover and/or on the bottom plate of the development cavity.

FIG. 4 is a schematic cross-section of suitable shapes of protruding elements.

The numbers in the Figures refer to the following features of a preferred apparatus according to the present invention :

| | |
|---|---|
| development unit | 5 |
| development cavity | 6 |
| cover plate | 7 |
| entry aperture | 8 |
| exit aperture | 9 |
| bottom plate | 10 |
| first part | 10A |
| second part | 10B |
| bend | 10C |
| roller pairs | 11A and 11B |
| development solution | 12 |
| drain | 18 |
| protruding element | 20 |
| sidewalls | 21 and 22 |

(continued)

processing direction 23

DETAILED DESCRIPTION OF THE INVENTION

Definitions

Development section : part of an apparatus which comprises a development unit and preferably also a developer recirculation system and a developer regeneration system.
Rinsing section : part of an apparatus which comprises a rinsing unit, and preferably also a rinse recirculation system and a rinse regeneration system.
Rinsing unit : vessel designed to hold rinse solution optionally including nip rollers and the like.
Gumming section : part of an apparatus which comprises a gumming unit, and preferably also a gum recirculation system and a gum regeneration system.
Development unit : vessel designed to hold development solution optionally including nip rollers and the like.
Fresh (development or gumming) solution : solution which has not yet been used for processing a plate material.
Gumming unit : vessel designed to hold gum solution optionally including nip rollers, scavenger rollers, brushe(s) and/or means for supplying gum solution to the plate.
(Re)circulation system : system comprising the necessary pipes and pump(s) to generate a flow of developer or gum solution.
Regeneration system : system comprising the necessary pipes and pump(s) to supply regenerator liquid to a development unit or a gumming unit.
Replenishment solution : regenerator liquid used to control the activity level of the development solution or the gum solution.
(Re)start : the process of draining developer and/or gum solution from the development unit or gum unit respectively, followed by refilling the development unit and/or gum unit with fresh developer or fresh gum solution respectively (the latter step taken alone is referred to as "start").
Unless otherwise indicated, parameter values of a solution, e.g. pH, density, viscosity, conductivity, etc. are always measured at 25°C.

Development

According to the current invention, an (exposed) printing plate material is developed by means of a suitable alkaline developer, also referred to as herein as "development solution" or "development liquid". In the development step, the non-printing areas of the coating of the plate material are at least partially removed without substantially removing the printing areas. In the event the non-printing areas are not completely removed by the development, complete removal may be achieved by the treatment with the aqueous solution.
Development of a plate material is typically performed in a vessel containing development solution, for example by dipping or immersing the plate in the developer, or by (spin-)coating, spraying and/or pouring developer onto the plate. The treatment with development solution may be combined with mechanical rubbing, e.g. by one, two or more rotating brushes and/or specified rollers e.g. Molton rollers. As most preferred embodiment, the development is carried out by the apparatus described hereafter. Preferably, the plate is not brushed during the treatment with alkaline development solution. During the development step, any water-soluble protective layer on top of the image-recording layer, if present, is preferably also removed.
During processing, the development solution becomes loaded with components of the coating that have been removed by the development and the amount of material in the development solution increases as more plates are developed. Due to this increasing amount of material in the development solution, the activity of the development solution typically decreases which may result in a reduced ability to remove the non-printing areas of the lithographic image and/or a reduced ability to maintain the removed components in solution or in a dispersed state. In addition, the pH of the development solution may decrease due to the dissolution of carbon dioxide from the air into the development solution as the time passes. Therefore, the development solution is preferably shielded from the air by a cover plate.
In a preferred embodiment, a low amount (as defined below) of development solution is used during a period of about one week or more, more preferably about two weeks or more, during which a plurality of plates is processed with the same development solution, either with or without regeneration. After that period, the development unit is reloaded with fresh development solution. This process is preferably fully automatic, which means that the development

solution is drained from the development unit and that the development unit is refilled with fresh developer by means of a system including a supply tank including fresh development solution, a waste tank for collecting the exhausted developer and the necessary pipes and pumps. The fresh development solution may be produced automatically inside the processing apparatus by diluting a more concentrated solution with water.

Because the development solution is used during just a limited period of time, only a negligible amount of sludge - such as salted-out compounds, precipitated or flocculated ingredients and/or other undissolved compounds - may be formed during the processing period between two (re)starts. Also, the level of dissolved ingredients and/or compounds present in the developing solution may be limited; i.e. the development solution is not exhausted. As a result, not only the maintenance of the development unit (as described below) becomes less burdensome, but also deposit on the exit and/or other rollers, and/or build-up on heater elements in the developer unit is limited as well as possible adherance of sludge on the printing plate which may impair the images formed thereon; e.g. accept ink in the non-image areas.

The apparatus described below is especially suited to enable to use a relatively small volume of development solution during a limited period of time between two (re)starts. In the context of this invention, a low amount of development solution refers to for example a volume below 50 1 e.g. between 1 and 20 1, preferably between 2 and 15 1, more preferably between 5 and 12 1 and most preferably between 8 and 10 1. The volume refers to the amount of development solution present in the development unit, i.e. excluding the volume that may be present in the regeneration system, in the recirculation system and in any supply and waste collector tanks. Said volume is dependent on the width of the development unit (which is typically between 0.5 m and 2.0 m), as explained below.

Preferably, the development solution is reloaded after one week of processing and/or after processing for example 400 m$^2$ of precursor. Preferably, the reloading of the development solution is automated.

Alternatively, the development quality may be kept constant for a longer period, so that a restart can be postponed for a longer time, for example more than one month, preferably more than two months, more preferably more than four months and most preferably more than six months. In this embodiment, a low volume of development solution as well as high volume of development solution may be used; however, a high volume of development solution is preferred, for example a volume between 5 and 200 1, preferably between 20 and 150 1, more preferably between 40 and 100 1 and most preferably between 60 and 90 1. As above, the actual amount depends on the width of the development unit.

The volume of the development solution in the development unit is preferably in the range Vmin to Vmax, which both depend on the width of the development unit according to the following formulae :

$$Vmax = [B + (W/0.95\ m)].liter \qquad (formula\ 1)$$

$$Vmin = [1 + (W/0.95\ m)].liter \qquad (formula\ 2)$$

wherein B represents an integer from 6 to 17 and wherein W is the width, expressed in meter and measured perpendicularly to the processing direction of the largest plate material that can be processed in the development unit (wherein the "processing direction" is defined as the path in the development unit along which the plate material travels during the treatment with development solution). Preferably B represents 6, 7, 8, 9 to 13, 14, 15, 16 or 17.

Regeneration of development solution

The activity level of the development solution may be maintained during its working period by adding replenishment solution. Depending on the concentration of the mentioned regenerator liquids, the rate of regeneration may be between 1 ml and 100 ml per m$^2$ of treated plate material, preferably between 2 ml/m$^2$ and 85 ml/m$^2$, 4 ml/m$^2$ and 60 ml/m$^2$, more preferably between 5 ml/m$^2$ and 30 ml/m$^2$.

It has been found that by using small amounts of developer for a limited period in time, little replenishment is required to keep the activity of the developer at a sufficient level and/or constant. Therefore, the embodiment wherein a small volume of developer is used generates, compared to development of the prior art where large amounts of developer for a longer period in time are used, less waste. Indeed, the waste - including the amount of drained developer and the amount of applied replenisher - generated during said limited period in time, is less compared to the waste that would have been generated when the development would have been carried out during a longer period in time.

In addition, the volume of development solution is preferably kept constant by for example adding water and/or development solution; also referred to in the art as *top-up* the development solution.

The mentioned regenerator liquids can be added continuously, after a predetermined period of time, and/or in batches when the activity of the development solution becomes too low and/or to keep the activity level constant. The activity level of the development solution can be determined by monitoring e.g. pH, density, viscosity conductivity, the number and/or area (square meters) of processed plates processed since a (re)start with fresh solution and/or the time

lapsed since a (re)start with fresh solution. When the addition of regenerator is regulated by measurement of one of these parameters, for example the conductivity of the development solution, the regenerator liquid can be added when a predetermined threshold value of that parameter is reached or is crossed. The amount of regenerator added each time depends on the predetermined threshold value. For example, when the measured parameter is the number of square meters of plate material processed, a predetermined amount of replenishment is added each time after processing a predetermined area of plate material. As a further example, the measured parameter can be the conductivity or conductivity increase of the solution monitored with a conductivity meter. Beyond a defined conductivity value, regenerator can automatically be added to the development solution.

The development unit preferably contains an overflow pipe which drains the development solution into a collector tank. The drained development solution may be purified and/or regenerated by e.g. filtration, decantation or centrifugation and then reused, however, the drained development solution is preferably collected for disposal.

Recirculation of development solution

The development solution present in the development unit can be circulated, e.g. by means of a circulation pump. In it most simple form, circulation means that a flow of development solution is generated within the development unit, preferably producing sufficient turbulence to enhance the removal of non-printing areas from the coating of the plate. As a result, during the treatment with the development solution, application of one or more brush(es) during the processing step is not required. In a preferred embodiment, the development cavity does not contain any brushes. The development solution may be sucked in via an outlet of the development unit, preferably near the exit rollers of the development unit, from where it may be drained to a waste collector tank.

According to a more preferred embodiment, at least a part of the development solution is not drained but recirculated, i.e. conveyed along a closed loop, e.g. from a sump of the development unit into one or more inlet openings such as for example spray or jet nozzles (as described further below), which apply the developer onto the plate and/or onto an optional brush which is in contact with the plate. Excess of developer then flows from the plate back into the sump. The most preferred embodiment of such recirculation involves pumping the developer into a development cavity, as described below.

During recirculation, the development solution is preferably at least partly removed (sucked) from the development unit and then injected through at least one inlet opening formed in for example the sidewall of the development cavity back into the development unit (or cavity, see further), thereby circulating and stirring the development solution. More preferably, the development solution which is sucked away is injected through at least one inlet opening in the development unit near the exit roller pair. Even more preferably, the development solution which is sucked away is injected through at least one inlet opening formed in the cover plate of the development unit and/or cavity. Most preferably, the development solution which is sucked away is injected through at least one spray bar which is preferably positioned in the development unit near the exit roller pair, more preferably parallel to the exit rollers. The development solution is preferably at least partly sucked in from the area under and/or near the exit rollers in the develoment unit. Preferably, a filter is present in the circulation system, e.g. in the pipes, which is capable of removing sludge and/or dissolved ingredients from the development solution.

Development solution

Any type of alkaline developer may be used in the method of the present invention, depending on the type of printing plate that is processed. Solvent-based or aqueous alkaline developers may be used. Solvent based developers have mainly been used to develop negative-working plate materials, while positive-working plate materials typically require a highly alkaline developer without much solvent therein.

Unless otherwise indicated, the amounts of developer ingredients given herein refer to the fresh developer as used for a (re)start. Such fresh developer may be obtained as a ready-to-use solution or by diluting a more concentrated solution that is supplied by the manufacturer with water, e.g. a dilution between 2 and 10 times. The dilution of a developer concentrate may be done in a separate apparatus or may be integrated in the processing apparatus. As a result, the preferred embodiments of this invention allow to develop plates with good clean-out by using less than 150 ml/$m^2$ of such concentrated solution, preferably less than 50 ml/$m^2$, and most preferably less than 20 ml/$m^2$ of such concentrated solution. 0.5 to 10 ml/$m^2$. Alternatively, 0.2 to 2 ml/$m^2$ of developer is preferably used.

A preferred alkaline developer is an aqueous solution which has a pH of at least 10, more typically at least 12, preferably from 13 to 14. Preferred high pH developers comprise at least one alkali metal silicate, such as lithium silicate, sodium silicate, and/or potassium silicate. Sodium silicate and potassium silicate are preferred, and sodium silicate is most preferred. A mixture of alkali metal silicates may be used if desired. Especially preferred high pH developers comprise an alkali metal silicate having a $SiO_2$ to $M_2O$ weight ratio of at least of at least 0.3, in which M is the alkali metal. Preferably, the ratio is from 0.3 to 1.2. More preferably, it is from 0.6 to 1.1, and most preferably, it is from 0.7 to

1.0. The amount of alkali metal silicate in the high pH developer is typically at least 20 g of $SiO_2$ per 1000 g of developer (that is, at least 2 wt.%) and preferably from 20 g to 80 g of $SiO_2$ per 1000 g of developer (2-8 wt.%). More preferably, it is 40 g to 65 g of $SiO_2$ per 1000 g of developer (4-6.5 wt.%).

In a highly preferred embodiment, as an alternative for the alkali metal silicate, alkalinity is provided by a suitable concentration of any suitable base. Such developers are referred to as "silicate-free" developers. Suitable bases include ammonium hydroxide, sodium hydroxide, lithium hydroxide, potassium hydroxide and/or organic amines, and/or mixtures thereof. A preferred base is sodium hydroxide. Such silicate-free developers do substantially exclude silicates; they are substantially silicate-free developers. The word "substantially" means that the presence of unavoidable impurities, minute silicates as byproduct and/or very small amounts which might have been added to the development solution, are tolerated. Very small amounts refer to for example less than 1%wt, preferably less than 0.5%wt and most preferably less than 0.1%wt, based on the total weight of the development solution.

Solvent-based alkaline developers preferably have a pH above 9, more preferably above 9.5, and most preferably above 10. Solvent-based developers comprise water and an organic solvent or a mixture of organic solvents. They are typically free of silicates (silicate-free see above), alkali metal hydroxides, and mixtures of silicates and alkali metal hydroxides. The developer is preferably a single phase. Consequently, the organic solvent or mixture of organic solvents is preferably either miscible with water or sufficiently soluble in the developer so that phase separation does not occur.

The following organic solvents and mixtures thereof are suitable for use in solvent-based developers: the reaction products of phenol with ethylene oxide (phenol ethoxylates) and with propylene oxide (phenol propoxylates), such as ethylene glycol phenyl ether (phenoxyethanol); benzyl alcohol; esters of ethylene glycol and of propylene glycol with acids having six or fewer carbon atoms, and ethers of ethylene glycol, diethylene glycol, and propylene glycol with alkyl groups having six or fewer carbon atoms, such as 2-ethoxyethanol, 2-(2-ethoxy)ethoxyethanol, and 2-butoxyethanol. A developer that comprises phenoxyethanol is preferred. The developer typically comprises 0.5 wt% to 15 wt%, preferably 3 wt% to 5 wt% of the organic solvent or solvents, based on the weight of the developer.

A suitable alternative developer for processing positive plates comprises a non-reducing sugar and a base. Such alkaline developers preferably have a pH above 9, more preferably above 10, and most preferably above 12. Such developers are typically free of silicates (silicate-free see above), alkali metal hydroxides, and mixtures of silicates and alkali metal hydroxides. The term "non-reducing sugar" means a saccharide which is free of free aldehyde or ketone group and thus is not reducing, e.g. trehalose type oligosaccharides, glycosides and sugar alcohols obtained by hydrogenating and reducing saccharides. Examples of the trehalose type oligosaccharides include saccharose, and trehalose. Examples of the glycosides include alkyl glycoside, phenol glycoside, and mustard oil glycoside. Examples of the sugar alcohols include D, L-arabitol, ribitol, xylitol, D,L-sorbitol, D,L-mannitol, D,L-iditol, D,L-talitol, dulcitol, and arodulicitol. Further, maltitol obtained by the hydrogenation of disaccharide or reduced material (reduced starch sirup) obtained by the hydrogenation of oligosaccharide may be used. Preferred among these non-reducing sugars are sugar alcohols and saccharose. Even more desirable among these non-reducing sugars are D-sorbitol, saccharose, and reduced starch sirup because they have buffer action within a proper pH range.

These non-reducing sugars may be used alone or in combination of two or more thereof. The proportion of these non-reducing sugars in the developer is preferably from 0.1 to 30% by weight, more preferably from 1 to 25% by weight.

The aforementioned non-reducing sugar may be used in combination with an alkaline agent as a base, properly selected from the group consisting of known materials such as inorganic alkaline agents, e.g. sodium hydroxide, potassium hydroxide, lithium hydroxide, trisodium phosphate, tripotassium phosphate, triammonium phosphate, disodium phosphate, dipotassium phosphate, diammonium phosphate, sodium carbonate, potassium carbonate, ammonium carbonate, sodium hydrogencarbonate, potassium hydrogencarbonate, ammonium hydrogencarbonate, sodium borate, potassium borate and ammonium borate, potassium citrate, tripotassium citrate, and sodium citrate.

Further preferred examples of alkaline agents include organic alkaline agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine and pyridine.

These alkaline agents may be used singly or in combination of two or more thereof. Preferred among these alkaline agents are sodium hydroxide, potassium hydroxide, trisodium phosphate, tripotassium phosphate, sodium carbonate and potassium carbonate.

Another alternative silicate-free and sugar-free alkaline aqueous developer composition has a pH of at least 12 and comprises (a) a hydroxide, (b) a metal cation M2' selected from barium, calcium, strontium, and zinc cations, (c) a chelating agent for the metal cation $M^+$ and (d) an alkali metal salt different than all of a, b, and c above.

Optional components of all the above mentioned developers are e.g. anionic, nonionic and/or amphoteric surfactants, biocides (antimicrobial and/or antifungal agents), antifoaming agents or chelating agents (such as alkali gluconates), solubilizers, image protecting agents such as blockers or retardants, dissolution inhibitors and thickening

agents (water soluble or water dispersible polyhydroxy compounds such as glycerin or polyethylene glycol).

Rinse solution

According to the present invention, the development described above is followed by treatment with an aqueous solution which contains a buffer which maintains the pH at a desired pH value and/or within a desired pH range. Said solution is also referred to herein as "the buffered rinse solution". The buffered rinse solution is preferably effective over a wide pH range, but it is preferred that the buffer maintains the pH value in a range from 0 to 10, more preferably 0.5 to 7 and most preferably 1 to 6. The buffered rinse solution mainly contains water - such as demineralised water, tap water, etc - and a sufficient amount of buffer so that the pH of the aqueous solution does not substantially change by adding strong acids or strong bases. The buffered rinse solution preferably essentially consists of a buffer and water. Unavoidable impurities and/or very small amounts of ingredients which do not have a specific and/or active functioning, are tolerated. Very small amounts refer to for example less than 1%wt, preferably less than 0.5%wt and most preferably less than 0.05%wt, based on the total weight of the development solution. The buffered rinse solution acts as a rinse and/or neutralising liquid. Preferably, the pH of the aqueous solution $\leq$ the pH of the gum solution. The buffered rinse solution provides a higher bath life to the gum solution (see further) as for example the pH of the gum solution will remain more stable and/or contamination by dragged out components will be reduced.

A buffer is typically an aqueous solution including a mixture of a weak acid and its conjugate base, or vice versa. Its pH changes very little when a small amount of strong acid or base is added to it. Buffer solutions are capable to keep the pH at a nearly constant value; in other words they regulate the pH. Buffer solutions achieve their resistance to pH change because of the presence of an equilibrium between the acid HA and its conjugate base $A^-$ :

$$HA \rightleftarrows H^+ + A^-$$

When some strong acid is added to such an equilibrium mixture of weak acid and its conjugate base, the equilibrium is shifted to the left, in accordance with Le Châtelier's principle. Because of this, the hydrogen ion concentration increases by less than the amount expected for the quantity of strong acid added. Similarly, if strong alkali is added to the mixture the hydrogen ion concentration decreases by less than the amount expected for the quantity of alkali added.

The pH changes relatively slowly in the buffer region which is pH = $pK_a \pm 1$ where [HA] = [$A^-$]. The hydrogen ion concentration decreases by less than the amount expected because most of the added hydroxide ion is consumed in the reaction:

$$OH^- + HA \rightarrow H_2O + A^-$$

and only a little is consumed in the neutralization reaction which results in an increase in pH:

$$OH^- + H^+ \rightarrow H_2O$$

Once the acid is more than 95% deprotonated the pH rises rapidly because then most of the added alkali is consumed in the neutralization reaction.

The resistance of a buffer solution to pH change on addition of hydroxide ions may be quantified and is referred to in the art as the buffer capacity. Depending on the specific combination of substances with $pK_a$ values differing by only two or less and adjusting the pH, a wide range of buffers can be obtained. For example mixtures can be made to cover the pH range 2.6 to 12. Preferred examples of buffers, without being limited hereto, are mixtures containing acids such as acetic acid, citric acid, oxalic acid, tartaric acid, benzoic acid, molybdic acid, boric acid, nitric acid, sulfuric acid, diethyl barbituric acid, phosphoric acid and polyphosphoric acid, and their water soluble alkali metal salts and ammonium salts. Specific examples thereof are ammonium acetate, sodium acetate, potassium acetate, sodium molybdate, potassium molybdate, sodium borate, ammonium borate, trisodium citrate, lithium nitrate, sodium nitrate, potassium nitrate, monosodium phosphate, sodium secondary phosphate, sodium tertiary phosphate, monopotassium phosphate, potassium secondary phosphate, potassium tertiary phosphate, ammonium tertiary phosphate, and sodium polyphosphate. Preferred buffers are mixtures containing acetic acid, benzoic acid, sulfuric acid, phosphoric acid and polyphosphoric acid, and their water soluble alkali metal salts and ammonium salts such as ammonium acetate, sodium acetate, potassium acetate, monosodium phosphate, sodium secondary phosphate, sodium tertiary phosphate, monopotassium phosphate, potassium secondary phosphate, potassium tertiary phosphate, ammonium tertiary phosphate, and sodium polyphosphate. The buffer may be an organic compound selected from saccharides, oximes, and fluorinated alcohols.

More information with regards to buffers suitably used in the current invention are described in CRC Handbook of Chemistry and Physics, 67 th Edition, 1986-1987, Buffer Solutions, Operational Definitions of pH by R.A. Robinson D-144 to D-146.

The plate material may be rinsed by immersing it in, spraying or jetting it with the buffered rinse solution as it passes through the processing apparatus. The material may also be subjected to mechanical rubbing with e.g. one or more rotating brushes or specified roller(s).

The buffered rinse solution is preferably regenerated by adding fresh buffered rinse solution, fresh water and/or fresh buffered rinse solution containing at least one ingredient with a different concentration, to compensate volume loss due to evaporation and carry over and/or to regenerate the buffered rinse solution efficiency.

Preferred embodiment: cascade configuration of the rinsing step

In a preferred embodiment, the rinsing step is in cascade configuration wherein, in a first and a second rinsing unit, a first and second rinsing step are carried out respectively which are configured as a cascade whereby the second buffered rinse solution overflows into the first rinsing unit. In the first rinsing step, the processed plate is treated with a first buffered rinse solution. In the second rinsing step, the plate material is subsequently treated with a second buffered rinse solution. The main purpose of these treatments is to rinse and/or neutralise the plate, i.e. the removal of any developer from the surface of the plate, and to ensure good clean-out of the image, if not already obtained in the development unit. Such a cascade configuration provides the advantage that sludge formation and/or contamination by for example carry-over of dissolved ingredients in the second buffered rinse solution is reduced, whereby the rinsing of the plate material as a whole becomes more efficient and faster. This rinsing section is also referred to as the "rinsing system".

The buffered rinse solution(s) are preferably brought into contact with the printing plate by spraying, jetting, immersing, dipping or by a coating technique, including spin coating, roll coating, slot coating or gravure coating. The use of spray bars is preferred. A spray bar typically includes a hollow rod with a predetermined series of holes. The rinsing unit(s) may also be provided with at least one roller for rubbing and/or brushing the plate while applying the buffered rinse solution to the coating.

Gumming

The rinsing step described above (one step or cascade two steps) may be followed by a gumming step. The gumming step involves post-treatment of the lithographic printing plate with a gum solution. A gum solution, as described below, is typically an aqueous liquid which comprises one or more surface protective compounds that are capable of protecting the lithographic image of a printing plate against contamination or damaging. Suitable examples of such compounds are film-forming hydrophilic polymers or surfactants. The layer that (in contrast with treatment with the buffered rinse solution where no layer is formed) preferably remains on the plate after treatment with the gum solution in the gumming step and drying preferably comprises between 0.05 and 20 $g/m^2$ of the surface protective compound; more preferably 0.1 to 15 $g/m^2$. This layer preferably remains on the plate until the plate is mounted on the press and is removed by the ink and/or fountain when the press run has been started. The plate precursor can, if required, be further post-treated with a suitable correcting agent or preservative as known in the art.

Preferred embodiment: cascade configuration of the gumming step

In a preferred embodiment of the present invention, the development and the rinsing steps (one step or cascade two steps) described above may be followed by at least two treatments with a gum solution, which is applied by means of a cascading gumming section comprising a first and a second gumming unit wherein a first and second gumming step are carried out respectively. This gumming section is also referred to as the "gumming system".

In the first gumming step, the processed plate is treated with a first gum solution. The main purpose of this treatment is to further rinse and/or neutralise the plate, i.e. the removal of any developer from the surface of the plate, and to ensure good clean-out of the image, if not already obtained in the development and/or rinsing units. In the second gumming step, the plate material is subsequently treated with a second gum solution. The main purpose of the second step is to protect the lithographic image by the application of a gum layer as further discussed below. It shall be understood, however, that the said purpose of the first and second gumming steps is not a limitation of the present invention. For instance, also the second gum solution may contribute to the clean-out of the image, for those plate materials of which the non-printing areas of the coating are not completely removed after the first gumming step. Reduced clean-out usually results in toning (ink-acceptance in the non-image areas) of the printing plate and/or in ink build-up on the blanket.

The gum solutions are preferably brought into contact with the printing plate by spraying, jetting, immersing, dipping or by a coating technique, including spin coating, roll coating, slot coating or gravure coating. The use of spray bars is preferred. A spray bar typically includes a hollow rod with a predetermined series of holes. The gumming unit(s) may also be provided with at least one roller for rubbing and/or brushing the plate while applying the gum to the coating.

In the current embodiment, the two gumming steps are carried out in two different gumming units configured

as a cascade whereby the second gum solution overflows into the first gumming unit. Such a cascade configuration provides the advantage that sludge formation and/or contamination by for example carry-over of dissolved ingredients in the second gum solution is reduced, whereby an increase of the viscosity of the gum solution in the second gumming unit can be reduced or inhibited. This results in an improved lifetime of the gumming system as only the gum solution of the first gumming unit becomes loaded with contaminants from the dragged out rinsing (and/or possibly development solution) solution, whereby the second gum solution can be used for gumming a higher number of plates so as to save costs and to enable a sustainable system. During the use of the method, the compositions of the two gum solutions may be different, although the first gum solution originates from the second gum solution via the cascade overflow. The difference may be due to for example contamination by dragged out components from the former section into the first gumming unit and/or by further dissolution of non-printing areas of the coating if clean out is not fully achieved by the development, further combined with for example insufficient regeneration of the first gum solution by the cascade overflow. The latter problem may be solved by actively pumping gum solution - in addition to the cascade overflow - from the second to the first gumming unit.

(Re)circulation of gum solution

The gum solution is preferably (re)circulated from a bath or sump into for example spray bars which supply the gum solution. The gum solution then flow back into the sump.

In the embodiment were a gum cascade is used, the first and/or second gum solutions are preferably (re)circulated, more preferably independently from one another. The first and second gum solutions are kept in respectively two baths or sumps from which they are recirculated into for example spray bars which supply the gum solution. The gum solutions then flow back into the respective sumps.

Preferably, a filter is present in the (re)circulation system, e.g. in the pipes, which is capable of removing any kind of sludge and/or dissolved ingredients from the gum solutions.

Regeneration of gum solution

The gum solutions may be regenerated by adding water or a replenishment solution or optionally diluted fresh gum solution, or a mixture thereof. Adding optionally diluted fresh gum solution is preferred.

A concentrated replenishment solution can be added as replenishment solution when the concentration of active products is under a desired level in the gum solution. A diluted replenishment solution or water can be used when the concentration of active products is above a desired level in the gum solution and/or when the viscosity of the gum solution is increased or when the volume of the gum solution is under a desired level, e.g. due to evaporation of the solvent or water.

The above mentioned regenerator liquids may be added to the first and/or second gum solution. The amount of regenerator added to the first gum solution may be restricted so as to compensate only for the volume which is drained in the cascade and dragged out with the plates. The amount of regenerator added to the second gum solution is preferably adjusted to compensate for the degradation of the gum solution by the dragged-out developer and for the volume which is drained as waste.

It is preferred that the amount of replenishment and/or gum solution added for the regeneration of gum solution, is small in order to limit the amount of waste produced during processing. Therefore, the rate of regeneration - depending on the concentration of the replenishment/gum solution - is preferably between 1 ml and 100 ml per $m^2$ of treated plates, more preferably between 2 $ml/m^2$ and 85 $ml/m^2$, more preferably between 4 $ml/m^2$ and 60 $ml/m^2$ and most preferably between 5 $ml/m^2$ and 30 $ml/m^2$.

The addition of regenerator, i.e. the type and the amount thereof, may be regulated by the measurement of for example the number and/or area of processed plates, the pH or pH change of the gum solution, the viscosity, the density, the time lapsed since the gumming system was loaded with fresh gum solution, or by monitoring the minimum and maximum volume in each gumming unit, or a combination of at least two of them.

The first gumming unit preferably contains an overflow pipe which drains the gum solution into a collector tank. The drained gum solution may be cleaned by e.g. filtration, decantation or centrifugation and then reused to regenerate the first and/or the second gum solution. Preferably however, the drained first gum solution is collected for disposal.

Gum solution

The composition of the gum solution described hereafter refers to the fresh gum solution that is used for a (re)start. Preferably, the same gum solution is used for the (re)start in both units of the gumming section. In alternative embodiments, a (re)start may involve filling the first and second gumming unit with different gum solutions, e.g. different concentrations obtained by a different dilution of the same gum solution. In that case, the composition of the gum solution

described herein refers to the fresh gum solution used in the second gumming unit. Such fresh gum solution may be obtained as a ready-to-use solution or by diluting a more concentrated solution that is supplied by the manufacturer. The dilution of a gum concentrate may be done in a separate apparatus or may be integrated in the processing apparatus.

Preferably, the second gum solution is reloaded after one week of processing and/or after processing for example 400 $m^2$ of precursor. Preferably, the reloading of the first and/or second gum solutions are automated.

Alternatively, the gum quality may be kept constant for a longer period, so that a restart can be postponed for a longer time, for example more than one month, preferably more than two months, more preferably more than four months and most preferably more than six months. According to the present invention, it was found that the gum quality can be kept constant for a substantially longer period due to the use of the buffered rinse solution compared to rinse solutions of the prior art.

Suitable gum solutions, to be used as fresh gum solution in the present invention, are aqueous liquids which comprise one or more surface protective compounds that are capable of protecting the lithographic image of a printing plate against contamination, oxidation or damaging. Suitable examples of such compounds are film-forming hydrophilic polymers or surfactants. In the current invention, a gum solution including film forming-hydrophilic polymers is preferred. The layer that remains on the plate after treatment with the gum solution in the second gumming step and drying preferably comprises between 0.1 and 20 $g/m^2$ of the surface protective compound. This layer typically remains on the plate until the plate is mounted on the press and is removed by the ink and/or fountain when the press run has been started. The gum solutions preferably have a pH below 11, more preferably below 9, even more preferably a pH from 0 to 8, and most preferably from 1 to 6. Suitable gum solutions used herein have a pH around 2, 4 or 5

A solution of a non-ionic surfactant and/or a solution of a buffer can be added when the gum solution needs a higher concentration of a surfactant or when the pH of the gum solution needs to be controlled at a desired pH value or at a desired pH value in a range of two pH values, e.g. between 0.5 and 9.

Processing apparatus

An apparatus which is especially designed for performing the processing methods of the present invention is described hereafter.

The Figures represent a highly preferred embodiment of such a processing apparatus, which includes a development section (1) a rinsing and a gumming section (not shown). The development section (1) preferably includes a development unit (5) comprising an essentially closed development cavity (6) comprising a cover plate (7), a bottom plate (10) and sidewalls (21,22).

Well known features which are preferably present in the development section of the apparatus but not shown in the Figures are : a feeder for delivering plates one by one to the development section; a (re)circulation and/or regeneration system; supply tanks comprising fresh developer, fresh gum solution, or one or more replenishing solutions; waste collector tanks wherein exhausted developer or gum solution are drained; a water tank to dilute concentrated chemistry; and other conventional parts.

When the description below refers to the plate material which during the operation of the apparatus travels through the various sections, it is assumed that the plate is facing upwards, i.e. with the heat- or light-sensitive coating facing upwards (the other side of the plate is referred to as "backside"). However, embodiments wherein the plate is facing downwards are equally within the scope of the present invention.

Preferred processing apparatus : development section

The development section (1) includes a development unit (5) which preferably comprises at least two roller pairs (11A, 11B) - also referred to as nip or feeder rollers - which convey the plates into and out of the development unit. The development unit preferably comprises a cover plate (7) to shield the development solution from the air.

Preferably, an entry roller pair (11A) feeds the plate into the development unit, more preferably into a development cavity (6) of the unit, which is an essentially closed volume defined by a bottom plate (10), a cover plate (7) and sidewalls (21,22). The cavity has an entry aperture (8) where the plate enters the cavity and an exit aperture (9) where the plate leaves the cavity. An exit roller pair (11B) preferably conveys the plate from the development section to the gumming section.

A rubber blade may be provided at the entry aperture to prevent air from flowing into the cavity. The development cavity is preferably completely filled with development solution without any air being present between the cover plate and the surface of the development solution. Preferably, the cover plate covering the development cavity is completely in contact with the liquid surface of the development solution so that any flow of air above the development solution - i.e. the flow of air from the entry aperture to the exit aperture - is cut off. The main function of the cover plate is to reduce possible degradation of the development solution by the absorption of carbon dioxide from the ambient air and/or evaporation of water, thereby allowing to reduce the rate of regeneration (if any). The cover plate may also extend

beyond the entry or exit aperture, e.g. the cover plate may include arc-shaped curves or rectangular shapes which cover the upper peripheral surfaces of the nip rollers.

The volume of the development cavity is preferably as low as possible. Preferably the volume of the cavity is from 0.5 $dm^3$ to 50 $dm^3$; more preferably from 1 $dm^3$ to 25 $dm^3$ and most preferably from 2 to 10 $dm^3$. In a preferred embodiment, the entry aperture (8) and exit aperature (9) are narrow slots which have an aspect ratio (height/width) of at least 10, more preferably at least 20. The height of the entry slot (8) is preferably between 2 and 5 times the thickness of the plate. The exit slot (9) is preferably more narrow, for example having a height only a few times (for example 2 to 3) bigger than the thickness of the plate.

The bottom plate (10) preferably includes at least two parts which are separated by an upward bend (10C) so that a first part of the bottom plate (10A) is oriented at an angle from 0.5° to 60° relative to a second part of the bottom plate (10B). More preferably, the angle is between 1° and 50°, more preferably between 5° and 45° and most preferably between 10° and 35° relative to the first part. The length (distance along the processing direction) of the first and/or second part of bottom plate is preferably adapted in order to obtain a smooth movement of the plate through the development cavity. Preferably, the first part (10A) has a length from 0 to 50 cm, more preferably from 1 to 30 cm and most preferred from 2 to 15 cm. The second part (10B) preferably has a length from 1 to 50 cm, more preferably from 2 to 30 cm and most preferably from 3 to 25 cm. Preferably, the upward bend is substantially perpendicular relative to the processing direction.

The surface of the bottom plate (10), which faces the inside of the development cavity, is preferably provided with one or more protruding elements (20), which maintain a distance between the backside of the plate and the bottom plate. Preferably, at least two protruding elements are present, more preferably at least three protruding elements are present and most preferably at least four protruding elements are present. As a result, formation of scratches at the backside of the plates is reduced and a smooth transport of the plate through the cavity is obtained. In addition, the protruding surface of the bottom plate may prevent contact between the plate and sludge such as salted-out compounds, precipitated or flocculated ingredients which are collected between the protruding elements.

The protruding elements may have any shape, e.g. spherical, rectangular, oval, triangular or longitudinal. FIG 4 illustrates suitable shapes of protruding elements. Preferred protruding elements are elongated ribs.

Preferably the cover plate is provided with at least two elongated ribs; more preferably at least three and most preferably at least four. These elements may be positioned parallel to each other. The length of the elongated rib(s) is preferably between 1 mm and 25 cm, more preferably between 5 mm and 15 cm and most preferably between 10 mm and 10 cm. The length may be at least the sum of the length of 10A and 10B. The height of the elongated rib(s) is preferably at least 0.1 mm and at most 50 mm, more preferably between 0.1 mm and 10 mm and most preferably between 1 mm and 5 mm. The elongated rib(s) may be oriented at an angle relative to the processing direction. Such elongated ribs may be parallel to the processing direction of the plate, indicated by the arrow (23) in FIG.3, but are more preferably oriented at an angle relative to the processing direction. Said angle ($\alpha$ in FIG. 3b) is for example 1 to 45° preferably 5 to 35° and most preferably 10 to 25° relative to the processing direction. Alternatively, the angle $\alpha$ may have a different value for one or more ribs, or in other words the ribs may be not fully parallel relative to each other.

In the preferred embodiment of FIG. 2a, the protruding elements (20) have a trapezoidal cross-section with a rounded top. The height of the protruding elements - measured at the heighest part in case of spherical, round or oval shapes - is preferably at least 0.1 mm and at most 50 mm, more preferably between 1 mm and 10 mm and most preferably between 1 mm and 5 mm.

These elements may be positioned for example ad random, grouped in a matrix, or along parallel lines. Such lines may be parallel to the processing direction of the plate but are more preferably oriented at an angle relative to the processing direction. Said angle ($\alpha$; as illustrated for elongated ribs in FIG. 3b) is for example 1 to 45° preferably 5 to 35° and most preferably 10 to 25° relative to the processing direction. Alternatively, the angle $\alpha$ may have a different value for one or more lines, or in other words the lines may be not fully parallel relative to each other. The length of the lines is preferably between 1 mm and 25 cm, more preferably between 5 mm and 15 cm and most preferably between 10 mm and 10 cm.

The protruding elements may be made from metal, fiber, and/or other flexible/ductile materials. The relief may be extruded, oriented, expanded, woven or tubular and can be made from polypropylene, polyethylene, nylon, PVC or PTFE. A metal relief may be woven, knitted, welded, expanded, photo-chemically etched or electroformed from steel or other metals.

As described above, the development solution is preferably regenerated by means of an inlet that supplies regenerator liquid to development unit (5) and/or development cavity (6). Other well known elements of the regenerator system are not shown in the Figures, such as a supply tank for replenishment solution; a pump and the necessary pipes to supply the regenerator liquid to the development unit (5) and/or development cavity (6).

Preferred processing apparatus : supply of developer by nozzles

In order to provide sufficient turbulence within the development unit, the developer is preferably applied onto the printing plate by means of nozzles which spray or jet a flow of developer on the surface of the plate. The nozzles may be configured as an array of nozzles, e.g. an array of holes in a spray bar or an array of jet nozzles in an inkjet head, e.g. a valve-jet head.

The use of nozzles is especially suitable for the embodiment wherein the development unit comprises a development cavity as described above. In that embodiment, the nozzles may be integrated in a sidewall or in both sidewalls of the development cavity so as to discharge development solution transversely over the coating of the plate. In the alternative, the nozzles may be present in the bottom or the cover plate, depending which of both is facing the image recording layer of the printing plate. Combined embodiments wherein nozzles are integrated in one or both sidewalls as well as in the bottom and/or the cover plate are also within the scope of this invention. The use of brushes is not required in order to obtain fast and efficient development of the plates. In a preferred embodiment, the development cavity does not contain any brushes whereby the risk of scratches on the image areas and/or maintenance (cleaning) of the brushes are eliminated.

The developer is preferably supplied by the nozzles as a pressurized flow over the surface area of the plate such that successive target areas of the plate are dynamically and uniformly flooded with development solution. The nozzle streams of development solution can be tuned with respect to direction, shape, overlap, and surface turbulence. Although the plate target area preferably experiences a continuous turbulent flooding, the supply through the nozzles can also be applied in consecutive pulses. Dissolution of the soluble coating regions is thereby achieved quickly and uniformly by providing a flow of developer liquid which causes turbulence and which is constantly displaced and replaced.

At sufficient volumetric flow rate, the development solution is constantly displaced at the surface of the plate during the development dwell time, whereby no boundary layer forms on and travels with the plate and each unit volume of coating is rapidly and uniformly processed. Preferably, depending on the speed at which the plate travels through the development unit, a turbulent flow of development solution is applied for a short dwell time onto each unit area of the coated plate; for example, at a speed between 0.5 and 5 m/min, a dwell time of less than about 30 seconds, more preferably a dwell time between 5 and 25 seconds and most prefrably a dwell time between 8 and 15 seconds. These figures are only a practical guideline and may be outside these ranges.

The use of brushes is not required in order to obtain fast and efficient development of the plates. In a preferred embodiment, the development cavity does not contain any brushes whereby the risk of scratches on the image areas and/or maintenance (cleaning) of the brushes are eliminated.

Suitable spray nozzles are commercially available in many sizes and configurations, e.g. from Spraying Systems Co. (Wheaton, Illinois, USA). Important parameters of the spray nozzles are the flow rate, the spray pressure, the drop size, the spray pattern and the spray nozzle alignment. Useful spray pressures are in the range of 1 to 5 bar, more preferably from 1.5 to 2.5 bar. A preferred spray pattern is a tapered-edge flat pattern because it can provide a uniform coverage over the entire plate area as a result of overlapping distributions. The angle of the spray cone and the spray distance between the spray nozzle and the plate define the target area on the plate. The nozzles may have a spray angle from 5° to 170°, the larger angle producing a large target area for a given spray distance. The nozzle target area on the plate depends on the spray angle and the spray distance and may be up to 15 cm, which can be achieved by a nozzle having e.g. a spray angle of 110° and a spray distance of 5 cm. However a smaller target area is preferred, e.g. less than 5 cm which may be achieved by a nozzle N with a spray angle of 50° and a 5 cm spray distance or 30° and 10 cm respectively. Suitable drop sizes of the spray are from less than 1 mm, e.g. 100 $\mu$m (achieved by so-called atomizing nozzles), up to a few mm, e.g. from 1 to 5 mm, preferably from 1 to 2 mm. The drop size is mainly determined by the spray pressure and of course the properties of the developer liquid.

The spray nozzles are preferably made of a material which is resistant to the developer liquid and provides a long wear life, e.g. stainless steel, a ceramic or a carbide. More information about spray nozzles can be found in e.g. the books "Industrial Sprays and Atomization", Springer, 1st edition (September 17, 2002) and "Handbook of Atomization and Sprays", Springer, 2011.

Especially when high-resolution nozzles, i.e. nozzles with a very small target area on the plate such as the nozzles of an inkjet head, are used, more intelligence can be built into the apparatus by supplying image data from the platesetter or the workflow software to the digital controller of the apparatus of the present invention. Image-controlled development can be achieved in the apparatus of the present invention by a digital controller wherein the average dot coverage at the target area of each nozzle, which is a portion of the image, is calculated and which adjusts the volume of developer deposited on that target area in accordance with said average dot coverage. In such embodiment, no developer is deposited on "full-black" portions of the image, i.e. portions which consist entirely of printing areas, and a sufficient amount of developer is deposited on the gray and white portions of the image, wherein said amount is made proportional to the average dot coverage of said gray and white portions. More details concerning suitable nozzles can be found in EP 2 775 351 (for example [0034] to [0049]).

Preferred processing apparatus : water rinsing section

The processing apparatus contains following the development section as described above, a water rinsing section. The rinsing section of the processing apparatus contains at least one rinsing unit.

In a preferred embodiment, the rinsing section of the processing apparatus contains at least two rinsing units which are provided in a cascade configuration, which means that the buffered rinse solution overflows from the second rinsing unit into the first rinsing unit. Additional rinsing units may be used, but the preferred embodiments comprise only two rinsing units. Preferably, the first buffered rinse solution does not allow overflow to the development section.

The buffered rinse solution is applied to the printing plate by a spraying, jetting, dipping or coating technique, including spin coating, roll coating, slot coating or gravure coating. The use of spray or (valve) jet nozzles is preferred. All features of the nozzles described above for supplying development solution equally apply to preferred embodiments for depositing rinse on the plate.

As described above, the second buffered rinse solution is preferably regenerated by means of an inlet that supplies regenerator buffered rinse liquid, which may be water and/or replenishment solution, to the second rinsing unit. Other well known elements of the regenerator system are not shown in the Figures, such as a supply tank for holding fresh buffered water solution, water or replenishment solution; a pump and the necessary pipes to supply the regenerator liquid to the second rinsing unit. Also the first buffered rinse solution may be regenerated, either by the same or an analogous regeneration system as used for the second rinse solution. The first rinse solution may also be regenerated by actively pumping rinse solution from the second to the first rinsing unit.

Preferred processing apparatus : gumming section

After the rinsing step, the printing plate is subjected to a gumming step. The gumming section of the processing apparatus contains at least one gumming unit.

Preferably, the gumming section of the processing apparatus contains at least two gumming units which are provided in a cascade configuration, which means that the gum solution overflows from the second gumming unit into the first gumming unit. Additional gumming units may be used, but the preferred embodiments comprise only two gumming units. Preferably, the first gumming unit does not allow overflow to the development section.

The gum solution(s) is preferably applied to the printing plate by a spraying, jetting, dipping or coating technique, including spin coating, roll coating, slot coating or gravure coating. The use of spray or (valve) jet nozzles is preferred. All features of the nozzles described above for supplying development solution equally apply to preferred embodiments for depositing gum on the plate, possibly in accordance with the plate area or even with the image data of the plate, as described in EP 2 775 351.

Preferred processing apparatus : drying section

After the (final) gum has been applied, the plate is preferably not rinsed but immediately conveyed to a drying section which is preferably integrated into the apparatus. Drying can be achieved by means (24) for emitting hot air, infrared and/or microwave radiation, and other methods generally known in the art. The plate may then be mounted on the plate cylinder of a printing press and the printing process may be started.

Lithographic printing plate materials

Any type of heat- and/or light-sensitive plate materials can be processed according to the methods and with the apparatus of the present invention. Preferred materials are positive or negative working plate materials which require alkaline processing. Positive working heat-sensitive materials are highly preferred.

*Support*

The preferred support of the lithographic printing plate material used in the present invention has a hydrophilic surface or is provided with a hydrophilic layer. A particularly preferred lithographic support is a grained and anodized aluminum support, more preferably aluminum grained by electrochemical graining in a solution comprising nitric acid and/or hydrochloric acid and then electrochemically anodized in a solution comprising phosphoric acid and/or sulphuric acid.

*Coating compositions*

The lithographic printing plate precursor used in the present invention can be negative or positive working, i.e.

can form ink-accepting areas at exposed or at non-exposed areas respectively. Below, suitable examples of heat- and light-sensitive coatings are discussed in detail.

Heat-sensitive printing plate precursors.

The imaging mechanism of the heat-sensitive printing plate precursors can be triggered by direct exposure to heat, e.g. by means of a thermal head, or by the light absorption of one or more compounds in the coating that are capable of converting light, more preferably infrared light, into heat. These heat-sensitive lithographic printing plate precursors are preferably not sensitive to visible light, i.e. no substantial effect on the dissolution rate of the coating in the developer is induced by exposure to visible light. Most preferably, the coating is not sensitive to ambient daylight.

A first suitable example of a thermal printing plate precursor is a precursor based on heat-induced coalescence of hydrophobic thermoplastic polymer particles which are preferably dispersed in a hydrophilic binder, as described in e.g. EP 770 494, EP 770 495, EP 770 497, EP 773 112, EP 774 364, EP 849 090, EP 1 614 538, EP 1 614 539, EP 1 614 540, EP 1 777 067, EP 1 767 349, WO 2006/037716, WO 2006/133741 and WO 2007/045515. According to a preferred embodiment, the thermoplastic polymer particles include styrene and acrylonitrile units in a weight ratio between 1:1 and 5:1 (styrene:acrylonitrile), e.g. in a 2:1 ratio. Examples of suitable hydrophilic binders are homopolymers and copolymers of vinyl alcohol, acrylamide, methylol acrylamide, methylol methacrylamide, acrylic acid, methacrylic acid, hydroxyethyl acrylate, hydroxyethyl methacrylate and maleic anhydride/vinylmethylether copolymers.

Preferably such a coating comprises an organic compound including at least one phosphonic acid group or at least one phosphoric acid group or a salt thereof, as described in WO 2007/04551.

In a second suitable embodiment, the thermal printing plate precursor comprises a coating comprising an aryldiazosulfonate homo- or copolymer which is hydrophilic and soluble in the processing liquid before exposure to heat or UV light and rendered hydrophobic and less soluble after such exposure.

Preferred examples of such aryldiazosulfonate polymers are the compounds which can be prepared by homo- or copolymerization of aryldiazosulfonate monomers with other aryldiazosulfonate monomers and/or with vinyl monomers such as (meth)acrylic acid or esters thereof, (meth)acrylamide, acrylonitrile, vinylacetate, vinylchloride, vinylidene chloride, styrene, $\alpha$-methyl styrene etc. Suitable aryldiazosulfonate monomers are disclosed in EP-A 339393, EP-A 507008 and EP-A 771645 and suitable aryldiazosulfonate polymers are disclosed in EP 507,008, EP 960,729, EP 960,730 and EP1,267,211.

A highly preferred thermal printing plate precursor is positive-working and inludes a coating which is based on heat-induced solubilization of an oleophilic resin. The oleophilic resin is preferably a polymer that is soluble in an aqueous developer, more preferably an aqueous alkaline development solution with a pH between 7.5 and 14. Preferred polymers are phenolic resins e.g. novolac, resoles, polyvinyl phenols and carboxy substituted polymers. Typical examples of these polymers are described in DE-A-4007428, DE-A-4027301 and DE-A-4445820. The coating preferably contains at least one layer which includes the phenolic resin(s). This layer is also referred to as "the imaging layer" or the first layer. The amount of phenolic resin present in the coating is preferably at least 50% by weight, preferably at least 80% by weight relative to the total weight of all the components present in the imaging layer.

In a preferred embodiment, the oleophilic resin is a phenolic resin wherein the phenyl group or the hydroxy group is chemically modified with an organic substituent. The phenolic resins which are chemically modified with an organic substituent may exhibit an increased chemical resistance against printing chemicals such as fountain solutions or plate treating liquids such as plate cleaners. Examples of such chemically modified phenolic resins are described in EP-A 0 934 822, EP-A 1 072 432, US 5 641 608, EP-A 0 982 123, WO 99/01795, EP-A 02 102 446, EP-A 02 102 444, EP-A 02 102 445, EP-A 02 102 443, EP-A 03 102 522. The modified resins described in EP-A 02 102 446, are preferred, especially those resins wherein the phenyl-group of said phenolic resin is substituted with a group having the structure -N=N-Q, wherein the -N=N- group is covalently bound to a carbon atom of the phenyl group and wherein Q is an aromatic group.

The oleophilic resin may also be mixed with or replaced by other polymers such as polymers including a urethane group and/or poly(vinyl acetal) resins. Suitable poly(vinyl acetal) resins which are added in order to improve the abrasion resistance of the coating are described in US 5,262,270; US 5,169,897; US 5,534,381; US 6,458,511; US 6,541,181; US 6,087,066; US 6,270,938; WO 2001/9682; EP 1 162 209; US 6,596,460; US 6,596,460; US 6,458,503; US 6,783,913; US 6,818,378; US 6,596,456; WO 2002/73315; WO 2002/96961; US 6,818,378; WO 2003/79113; WO 2004/20484; WO 2004/81662; EP 1 627 732; WO 2007/17162; WO 2008/103258; US 6,087,066; US 6,255,033; WO 2009/5582; WO 2009/85093; WO 2001/09682; US 2009/4599; WO 2009/99518; US 2006/130689; US 2003/166750; US 5,330,877; US 2004/81662; US 2005/3296; EP 1 627 732; WO 2007/3030; US 2009/0291387; US 2010/47723 and US 2011/0059399.

The poly(vinyl acetal) resin preferably contains the following acetal moiety:

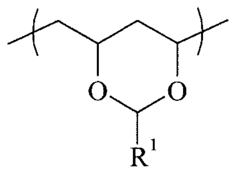

wherein $R^1$ represents an aliphatic carbon chain such as a methyl, ethyl, propyl, butyl or pentyl group, an optionally substituted aryl group such as a phenyl, benzyl, naphthyl, tolyl, ortho- meta- or para-xylyl, anthracenyl or phenanthrenyl, or an optionally substituted heteroaryl group such as a pyridyl, pyrimidyl, pyrazoyl, triazinyl, imidazolyl, furyl, thienyl, isoxazolyl, thiazolyl and carbazoyl group. Most preferably the vinyl acetale is selected from vinyl formal, vinyl ethyral, vinyl propyral and/or vinyl butyral.

Preferred poly(vinyl acetal) resins are copolymers comprising acetal moieties and ethylenic moieties as described in WO2014/106554, WO2015/158566 , WO2015/173231, WO2015/189092 and WO2016/001023. Especially preferred poly(vinyl acetale) resins are resins including ethylenic moieties and acetal moieties including an optionally substituted aromatic or heteroaromatic group including at least one hydroxyl group (WO2014/106554), or poly(vinyl acetale) resins including an optionally substituted aromatic or heteroaromatic group are resins including at least one hydroxyl group in ortho or para position relative to an electron withdrawing group (WO2015/158566).

The coating may further comprise a second layer that comprises one or more other binder(s) which is insoluble in water and soluble in an alkaline solution such as an organic polymer which has acidic groups with a pKa of less than 13 to ensure that the layer is soluble or at least swellable in aqueous alkaline developers. This layer is located between the layer described above comprising the oleophilic resin i.e. the imaging layer, and the hydrophilic support. This layer is also referred to as "the second layer". The binder may be selected from a polyester resin, a polyamide resin, an epoxy resin, an acrylic resin, a methacrylic resin, a styrene based resin, a polyurethane resin or a polyurea resin. The binder may be selected from a polyester resin, a polyamide resin, an epoxy resin, an acrylic resin, a methacrylic resin, a styrene based resin, a polyurethane resin or a polyurea resin. The binder may have one or more functional groups. The functional group(s) can be selected from the list of

(I) a sulfonamide group such as $-NR-SO_2-$, $-SO_2-NR-$ or $-SO_2-NR'R''$ wherein R and R' independently represent hydrogen or an optionally substituted hydrocarbon group such as an optionally substituted alkyl, aryl or heteroaryl group; more details concerning these polymers can be found in EP 2 159 049;
(II) a sulfonamide group including an acid hydrogen atom such as $-SO_2-NH-CO-$ or $-SO_2-NH-SO_2-$ as for example disclosed in US 6,573,022 and/or EP 909 68(of 5)7 ; suitable examples of these compounds include for example N-(p-toluenesulfonyl) methacrylamide and N-(p-toluenesulfonyl) acrylamide;
(III) an urea group such as -NH-CO-NH-, more details concerning these polymers can be found in WO 01/96119;
(IV) a star polymer in which at least three polymer chains are bonded to a core as described in EP 2 497 639;
(V) a carboxylic acid group;
(VI) a nitrile group;
(VII) a sulfonic acid group;
(VIII) a phosphoric acid group and/or
(IX)a urethane group.

(Co)polymers including a sulfonamide group are preferred. Sulfonamide (co)polymers are preferably high molecular weight compounds prepared by homopolymerization of monomers containing at least one sulfonamide group or by copolymerization of such monomers and other polymerizable monomers. Preferably, in the embodiment where the poly(vinyl acetale) binder of the present invention is present in the first layer, the copolymer comprising at least one sulfonamide group is present in the second layer located between the layer including the poly(vinyl acetale) binder of the present invention and the hydrophilic support.

Examples of monomers copolymerized with the monomers containing at least one sulfonamide group include monomers as disclosed in EP 1 262 318, EP 1 275 498, EP 909 657, EP 1 120 246, EP 894 622, US 5,141,838, EP 1 545 878 and EP 1 400 351. Monomers such as alkyl or aryl (meth)acrylate such as methyl (meth)acrylate, ethyl (meth)acrylate, butyl (meth)acrylate, benzyl (meth)acrylate, 2-phenylethyl (meth)acrylate, hydroxylethyl (meth)acrylate, phenyl (meth)acrylate; (meth)acrylic acid; (meth)acrylamide; a N- alkyl or N-aryl (meth)acrylamide such as N-methyl (meth)acrylamide, N-ethyl (meth)acrylamide, N-phenyl (meth)acrylamide, N-benzyl (meth)acrylamide, N-methylol (meth)acrylamide, N-(4-hydroxyphenyl)(meth)acrylamide, N-(4-methylpyridyl)(meth)acrylate; (meth)acrylonitrile; styrene; a substituted styrene such as 2-, 3- or 4-hydroxy-styrene, 4-benzoic acid-styrene; a vinylpyridine such as 2-vinylpyridine, 3-vinylpyridine, 4-vinylpyridine; a substituted vinylpyridine such as 4-methyl-2-vinylpyridine; vinyl acetate, optionally the copolymerised vinyl acetate monomeric units are at least partially hydrolysed, forming an alcohol group, and/or at least

partially reacted by an aldehyde compound such as formaldehyde or butyraldehyde, forming an acetal or butyral group; vinyl alcohol; vinyl acetal; vinyl butyral; a vinyl ether such as methyl vinyl ether; vinyl amide; a N-alkyl vinyl amide such as N-methyl vinyl amide, caprolactame, vinyl pyrrolydone; maleimide; a N-alkyl or N-aryl maleimide such as N-benzyl maleimide, are preferred.

Suitable examples of sulfonamide (co)polymers and/or their method of preparation are disclosed in EP 933 682, EP 982 123, EP 1 072 432, WO 99/63407, EP 1 400 351 and EP 2 159 049. A highly preferred example of a sulfonamide (co)polymer is described in EP 2 047 988 A in [0044] to [0046].

Specific preferred examples of sulphonamide (co)polymers are polymers comprising N-(p-aminosulfonylphenyl) (meth)acrylamide, N-(m-aminosulfonylphenyl) (meth)acrylamide N-(o-aminosulfonylphenyl) (meth)acrylamide and or m-aminosulfonylphenyl (meth)acrylate.

(Co)polymers including an imide group are also preferred as a binder in the heat-sensitive coating. Specific examples include derivatives of methyl vinyl ether/maleic anhydride copolymers and derivatives of styrene/maleic anhydride copolymers, that contain an N-substituted cyclic imide monomeric units and/or N-substituted maleimides such as a N-phenylmaleimide monomeric unit and a N-benzyl-maleimide monomeric unit. This copolymer is preferably alkali soluble. Suitable examples are described in EP 933 682, EP 894 622 A [0010] to [0033], EP 901 902, EP 0 982 123 A [007] to [0114], EP 1 072 432 A [0024] to [0043] and WO 99/63407 (page 4 line 13 to page 9 line 37).

Polycondensates and polymers having free phenolic hydroxyl groups, as obtained, for example, by reacting phenol, resorcinol, a cresol, a xylenol or a trimethylphenol with aldehydes, especially formaldehyde, or ketones, may also be added to the heat-sensitive coating. Condensates of sulfamoyl- or carbamoyl-substituted aromatics and aldehydes or ketones are also suitable. Polymers of bismethylol-substituted ureas, vinyl ethers, vinyl alcohols, vinyl acetals or vinylamides and polymers of phenylacrylates and copolymers of hydroxy-phenylmaleimides are likewise suitable. Furthermore, polymers having units of vinylaromatics or aryl (meth)acrylates may be mentioned, it being possible for each of these units also to have one or more carboxyl groups, phenolic hydroxyl groups, sulfamoyl groups or carbamoyl groups. Specific examples include polymers having units of 2-hydroxyphenyl (meth)acrylate, of 4-hydroxystyrene or of hydroxyphenylmaleimide. The polymers may additionally contain units of other monomers which have no acidic units. Such units include vinylaromatics, methyl (meth)acrylate, phenyl(meth)acrylate, benzyl (meth)acrylate, methacrylamide or acrylonitrile.

The dissolution behavior of the coating can be fine-tuned by optional solubility regulating components. More particularly, developability enhancing compounds, development accelerators and development inhibitors can be used. In the embodiment where the coating comprises more than one layer, these ingredients can be added to the first layer and/or to the second layer and/or to an optional other layer of the coating.

Suitable developability enhancing compounds are (i) compounds which upon heating release gas as disclosed in WO 2003/79113, (ii) the compounds as disclosed in WO 2004/81662, (iii) the compositions that comprises one or more basic nitrogen-containing organic compounds as disclosed in WO 2008/103258 and (iv) the organic compounds having at least one amino group and at least one carboxylic acid group as disclosed in WO 2009/85093.

Examples of basic nitrogen-containing organic compounds useful in the developability-enhancing compositions are N-(2-hydroxyethyl)-2- pyrrolidone, 1 -(2-hydroxyethyl)piperazine, N-phenyldiethanolamine, triethanolamine, 2-[bis(2-hydroxyethyl)amino]-2-hydroxymethyl-1.3-propanediol, N,N,N',N'-tetrakis(2-hydroxyethyl)-ethylenediamine, N,N,N',N'-tetrakis(2- hydroxypropyl)-ethylenediamine, 3-[(2-hydroxyethyl)phenylamino]propionitrile, and hexahydro-1,3,5-tris(2-hydroxyethyl)-s-triazine. Preferably N,N,N',N'-tetrakis(2-hydroxypropyl)-ethylenediamine is used. Mixtures of two or more of these compounds are also useful. The basic nitrogen-containing organic compounds can be obtained from a number of commercial sources including BASF (Germany) and Aldrich Chemical Company (Milwaukee, WI).

The basic nitrogen-containing organic compound(s) is preferably present in the coating in an amount of from 1 to 30 %wt, and typically from 3 to 15 %wt, based on the total solids of the coating composition.

Preferably, one or more of the basic nitrogen-containing organic compounds are used in combination with one or more acidic developability-enhancing compounds, such as carboxylic acids or cyclic acid anhydrides, sulfonic acids, sulfinic acids, alkylsulfuric acids, phosphonic acids, phosphinic acids, phosphonic acid esters, phenols, sulfonamides, or sulfonimides, since such a combination may permit further improved developing latitude and printing durability. Representative examples of the acidic developability-enhancing compounds are provided in [0030] to [0036] of US 2005/0214677. They may be present in an amount of from 0.1 to 30 %wt based on the total dry weight of the coating composition. The molar ratio of one or more basic nitrogen-containing organic compounds to one or more acidic developability-enhancing compounds is generally from 0.1: 1 to 10:1 and more typically from 0.5: 1 to 2: 1.

Development accelerators are compounds which act as dissolution promoters because they are capable of increasing the dissolution rate of the coating. For example, cyclic acid anhydrides, phenols or organic acids can be used in order to improve the aqueous developability. Examples of the cyclic acid anhydride include phthalic anhydride, tetrahydrophthalic anhydride, hexahydrophthalic anhydride, 3,6-endoxy-4-tetrahydro-phthalic anhydride, tetrachlorophthalic anhydride, maleic anhydride, chloromaleic anhydride, alpha -phenylmaleic anhydride, succinic anhydride, and pyromellitic anhydride, as described in U.S. Patent No. 4,115,128. Examples of the phenols include bisphenol A, p-nitrophenol, p-ethoxyphenol, 2,4,4'-trihydroxybenzophenone, 2,3,4-trihydroxy-benzophenone, 4-hydroxybenzophenone, 4,4',4"-trihydroxy-triphenylmethane, and 4,4',3",4"-tetrahydroxy-3,5,3',5'-tetramethyltriphenyl-methane, and the like. Examples of the organic acids include sulphonic acids, sulfinic acids, alkylsulfuric acids, phosphonic acids, phosphates, and carboxylic acids, as described in, for example, JP-A Nos. 60-88,942 and 2-96,755. Specific examples of these organic acids include p-toluenesulphonic acid, dodecylbenzenesulphonic acid, p-toluenesulfinic acid, ethylsulfuric acid, phenylphosphonic acid, phenylphosphinic acid, phenyl phosphate, diphenyl phosphate, benzoic acid, isophthalic acid, adipic acid, p-toluic acid, 3,4-dimethoxybenzoic acid, 3,4,5-trimethoxybenzoic acid, 3,4,5-trimethoxycinnamic acid, phthalic acid, terephthalic acid, 4-cyclohexene-1,2-dicarboxylic acid, erucic acid, lauric acid, n-undecanoic acid, and ascorbic acid. The amount of the cyclic acid anhydride, phenol, or organic acid contained in the coating is preferably in the range of 0.05 to 20% by weight, relative to the coating as a whole. Polymeric development accelerators such as phenolic-formaldehyde resins comprising at least 70 mol% meta-cresol as recurring monomeric units are also suitable development accelerators.

In a preferred embodiment, the coating also contains developer resistance means, also called development inhibitors, i.e. one or more ingredients which are capable of delaying the dissolution of the unexposed areas during processing. The dissolution inhibiting effect is preferably reversed by heating, so that the dissolution of the exposed areas is not substantially delayed and a large dissolution differential between exposed and unexposed areas can thereby be obtained. The compounds described in e.g. EP 823 327 and WO 97/39894 act as dissolution inhibitors due to interaction, e.g. by hydrogen bridge formation, with the alkalisoluble resin(s) in the coating. Inhibitors of this type typically are organic compounds which include at least one aromatic group and a hydrogen bonding site such as a nitrogen atom which may be part of a heterocyclic ring or an amino substituent, an onium group, a carbonyl, sulfinyl or sulfonyl group. Suitable dissolution inhibitors of this type have been disclosed in e.g. EP 825 927 and EP 823 327. Some of the compounds mentioned below, e.g. infrared dyes, such as cyanines, and contrast dyes, such as quaternized triarylmethane dyes, can also act as a dissolution inhibitor.

Other suitable inhibitors improve the developer resistance because they delay the penetration of the aqueous alkaline developer into the coating. Such compounds can be present in the first layer and/or in the optional second layer and/or in a development barrier layer on top of said layer, as described in e.g. EP 864 420, EP 950 517, WO 99/21725 and WO 01/45958. The solubility and/or penetrability of the barrier layer in the developer can be increased by exposure to heat and/or infrared light.

Water-repellent polymers represent another type of suitable dissolution inhibitors. Such polymers seem to increase the developer resistance of the coating by repelling the aqueous developer from the coating. In the embodiment where the coating comprises more than one layer, the water-repellent polymers can be added to the first layer and/or to the second layer and/or in a separate layer provided on top of these layers. In the latter embodiment, the water-repellent polymer forms a barrier layer which shields the coating from the developer and the solubility of the barrier layer in the developer or the penetrability of the barrier layer by the developer can be increased by exposure to heat or infrared light, as described in e.g. EP 864 420, EP 950 517 and WO99/21725.

Preferred examples of inhibitors which delay the penetration of the aqueous alkaline developer into the coating include water-repellent polymers including siloxane and/or perfluoroalkyl units. The polysiloxane may be a linear, cyclic or complex cross-linked polymer or copolymer. The term polysiloxane compound shall include any compound which contains more than one siloxane group -Si(R,R')-O-, wherein R and R' are optionally substituted alkyl or aryl groups. Preferred siloxanes are phenylalkylsiloxanes and dialkylsiloxanes. The number of siloxane groups in the polymer is at least 2, preferably at least 10, more preferably at least 20. It may be less than 100, preferably less than 60.

The water-repellent polymer may be a block-copolymer or a graft-copolymer including a polar block such as a poly- or oligo(alkylene oxide) and a hydrophobic block such as a long chain hydrocarbon group, a polysiloxane and/or a perfluorinated hydrocarbon group. A typical example of a perfluorinated surfactant is Megafac F-177 available from Dainippon Ink & Chemicals, Inc.. Other suitable copolymers comprise about 15 to 25 siloxane units and 50 to 70 alkyleneoxide groups. Preferred examples include copolymers comprising phenylmethylsiloxane and/or dimethylsiloxane as well as ethylene oxide and/or propylene oxide, such as Tego Glide 410, Tego Wet 265, Tego Protect 5001 or Silikophen P50/X, all commercially available from Tego Chemie, Essen, Germany.

A suitable amount of such a water-repellent polymer in the coating is between 0.5 and 25 $mg/m^2$, preferably between 0.5 and 15 $mg/m^2$ and most preferably between 0.5 and 10 $mg/m^2$. When the water-repellent polymer is also ink-repelling, e.g. in the case of polysiloxanes, higher amounts than 25 $mg/m^2$ can result in poor ink-acceptance of the non-exposed areas. An amount lower than 0.5 $mg/m^2$ on the other hand may lead to an unsatisfactory development resistance.

It is believed that during coating and drying, the water-repellent polymer or copolymer acts as a surfactant and tends to position itself, due to its bifunctional structure, at the interface between the coating and air and thereby forms a separate top layer, even when applied as an ingredient of the coating solution. Simultaneously, such surfactants also act as spreading agents which improve the coating quality. Alternatively, the water-repellent polymer or copolymer can be applied in a separate solution, coated on top of the coating including one or optional more layers. In that embodiment,

it may be advantageous to use a solvent in the separate solution that is not capable of dissolving the ingredients present in the other layers so that a highly concentrated water-repellent phase is obtained at the top of the coating.

The coating of the heat-sensitive printing plate precursors described above preferably also contains an infrared light absorbing dye or pigment which, in the embodiment where the coating comprises more than one layer, may be present in the first layer, and/or in the second layer, and/or in an optional other layer. Preferred IR absorbing dyes are cyanine dyes, merocyanine dyes, indoaniline dyes, oxonol dyes, pyrilium dyes and squarilium dyes. Examples of suitable IR dyes are described in e.g. EP-As 823327, 978376, 1029667, 1053868, 1093934; WO 97/39894 and 00/29214. Preferred compounds are the following cyanine dyes:

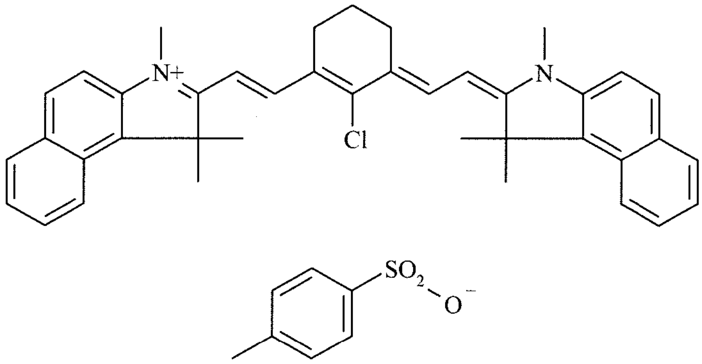

IR-1

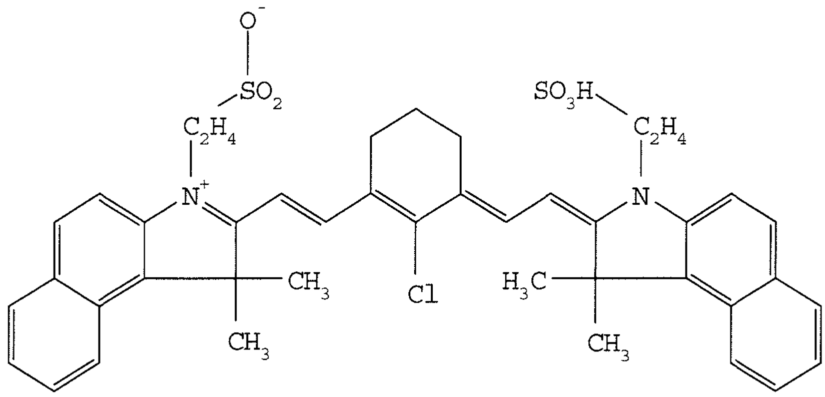

IR-2

The concentration of the IR-dye in the coating is preferably between 0.25 and 15.0 %wt, more preferably between 0.5 and 10.0 %wt, most preferably between 1.0 and 7.5 %wt relative to the coating as a whole.

The coating may further comprise one or more colorant(s) such as dyes or pigments which provide a visible color to the coating and which remain in the coating at the image areas which are not removed during the processing step. Thereby a visible image is formed and examination of the lithographic image on the developed printing plate becomes feasible. Such dyes are often called contrast dyes or indicator dyes. Preferably, the dye has a blue color and an absorption maximum in the wavelength range between 600 nm and 750 nm. Typical examples of such contrast dyes are the amino-substituted tri- or diarylmethane dyes, e.g. crystal violet, methyl violet, victoria pure blue, flexoblau 630, basonylblau 640, auramine and malachite green. Also the dyes which are discussed in depth in EP-A 400,706 are suitable contrast dyes. Dyes which, combined with specific additives, only slightly color the coating but which become intensively colored after exposure, as described in for example WO2006/005688 may also be used as colorants.

Optionally, the coating may further contain additional ingredients such as surfactants, especially perfluoro surfactants, silicon or titanium dioxide particles or polymers particles such as matting agents and spacers.

Any coating method can be used for applying one or more coating solutions to the hydrophilic surface of the support. The multi-layer coating can be applied by coating/drying each layer consecutively or by the simultaneous coating of several coating solutions at once. In the drying step, the volatile solvents are removed from the coating until the coating is self-supporting and dry to the touch. However it is not necessary (and may not even be possible) to remove all the

solvent in the drying step. Indeed the residual solvent content may be regarded as an additional composition variable by means of which the composition may be optimized. Drying is typically carried out by blowing hot air onto the coating, typically at a temperature of at least 70°C, suitably 80-150°C and especially 90-140°C. Also infrared lamps can be used. The drying time may typically be 15-600 seconds.

Between coating and drying, or after the drying step, a heat treatment and subsequent cooling may provide additional benefits, as described in WO99/21715, EP-A 1074386, EP-A 1074889, WO00/29214, and WO/04030923, WO/04030924, WO/04030925.

The printing plate precursor can be exposed to infrared light by means of e.g. LEDs or a laser. Most preferably, the light used for the exposure is a laser emitting near infrared light having a wavelength in the range from about 750 to about 1500 nm, more preferably 750 to 1100 nm, such as a semiconductor laser diode, a Nd:YAG or a Nd:YLF laser. The required laser power depends on the sensitivity of the plate precursor, the pixel dwell time of the laser beam, which is determined by the spot diameter (typical value of modern plate-setters at $1/e^2$ of maximum intensity : 5-25 $\mu$m), the scan speed and the resolution of the exposure apparatus (i.e. the number of addressable pixels per unit of linear distance, often expressed in dots per inch or dpi; typical value : 1000-4000 dpi).

<u>Light-sensitive printing plate precursors.</u>

In addition to the above thermal materials, also light-sensitive coatings can be used. Typical examples of such plates are the UV-sensitive "PS" plates and the so-called photopolymer plates which contain a photopolymerizable composition that hardens upon exposure to light.

In a particular embodiment of the present invention, a conventional, UV-sensitive "PS" plate precursor is used. Suitable examples of such plates precursors, that are sensitive in the range of 300-450 nm (near UV and blue light), have been discussed in EP 1,029,668 A2. Positive and negative working compositions are typically used in "PS" plate precursors.

The positive working imaging layer preferably comprises an o-naphtoquinonediazide compound (NQD) and an alkali soluble resin. Particularly preferred are o-naphthoquinone-diazidosulphonic acid esters or o-naphthoquinone diazidocarboxylic acid esters of various hydroxyl compounds and o-naphthoquinone-diazidosulphonic acid amides or o-naphthoquinone-diazidocarboxylic acid amides of various aromatic amine compounds. Two variants of NQD systems can be used: one-component systems and two-component systems. Such light-sensitive printing plates have been widely disclosed in the prior art, for example in U.S. 3,635,709, J.P. KOKAI No. 55-76346, J.P. KOKAI No. Sho 50-117503, J.P. KOKAI No. Sho 50-113305, U.S. 3,859,099; U.S. 3,759,711; GB-A 739654, US 4,266,001 and J.P. KOKAI No. 55-57841.

The negative working layer of a "PS" plate preferably comprises a diazonium salt, a diazonium resin or an aryldiazosulfonate homo- or copolymer. Suitable examples of low-molecular weight diazonium salts include: benzidine tetrazoniumchloride, 3,3'-dimethylbenzidine tetrazoniumchloride, 3,3'-dimethoxybenzidine tetrazoniumchloride, 4,4'-diaminodiphenylamine tetrazoniumchloride, 3,3'-diethylbenzidine tetrazoniumsulfate, 4-aminodiphenylamine diazoniumsulfate, 4-aminodiphenylamine diazoniumchloride, 4-piperidino aniline diazoniumsulfate, 4-diethylamino aniline diazoniumsulfate and oligomeric condensation products of diazodiphenylamine and formaldehyde. Examples of diazo resins include condensation products of an aromatic diazonium salt as the light-sensitive substance. Such condensation products are described, for example, in DE-P-1 214 086. The light- or heat-sensitive layer preferably also contains a binder e.g. polyvinyl alcohol.

Upon exposure the diazo resins or diazonium salts are converted from water soluble to water insoluble (due to the destruction of the diazonium groups) and additionally the photolysis products of the diazo may increase the level of crosslinking of the polymeric binder or diazo resin, thereby selectively converting the coating, in an image pattern, from water soluble to water insoluble. The unexposed areas remain unchanged, i.e. water-soluble.

Such printing plate precursors can be developed using an aqueous alkaline solution as described above.

In a second suitable embodiment, the light sensitive printing plate precursor is based on a photo-polymerisation reaction and contains a coating comprising a photocurable composition comprising a free radical initiator (as disclosed in for example US 5,955,238; US 6,037,098; US 5,629,354; US 6,232,038; US 6,218,076; US 5,955,238; US 6,037,098; US 6,010,824; US 5,629,354; DE 1,470,154; EP 024,629; EP 107,792; US 4,410,621; EP 215,453; DE 3,211,312 and EP A 1,091,247) a polymerizable compound ((as disclosed in EP 1 161 4541, EP 1 349 006, WO2005/109103, EP 1 788 448, EP 1 788 435, EP 1 788 443, EP 1 788 434) and a polymeric binder (as disclosed in for example US2004/0260050, US2005/0003285; US2005/0123853; EP 1,369,232; EP 1,369,231; EP 1,341,040; US 2003/0124460, EP 1 241 002, EP 1 288 720, US 6,027,857, US 6,171,735; US 6,420,089; EP 152,819; EP 1,043, 627; US 6,899,994; US2004/0260050; US 2005/0003285; US2005/0170286; US2005/0123853; US2004/0260050; US2005/0003285; US 2004/0260050; US 2005/0003285; US 2005/0123853 and US2005/0123853). Other ingredients such as sensitizers, co-initiators, inhibitors, adhesion promoting compounds, colorants, surfactants and/or printing out agents may optionally be added. These printing plate precursors can be sensitized with blue, green or red light (i.e. wavelength range between 450 and 750

nm), with violet light (i.e. wavelength range between 350 and 450 nm) or with infrared light (i.e. wavelength range between 750 and 1500 nm) using for example an Ar laser (488 nm) or a FD-YAG laser (532 nm), a semiconductor laser InGaN (350 to 450 nm), an infrared laser diode (830 nm) or a Nd-YAG laser (1064 nm).

To protect the surface of the coating of the heat and/or light sensitive printing plate precursors, in particular from mechanical damage, a protective layer may also optionally be applied. The protective layer generally comprises at least one water-soluble binder, such as polyvinyl alcohol, polyvinylpyrrolidone, partially hydrolyzed polyvinyl acetates, gelatin, carbohydrates or hydroxyethylcellulose, and can be produced in any known manner such as from an aqueous solution or dispersion which may, if required, contain small amounts - i.e. less than 5% by weight based on the total weight of the coating solvents for the protective layer - of organic solvents. The thickness of the protective layer can suitably be any amount, advantageously up to 5.0 $\mu$m, preferably from 0.1 to 3.0 $\mu$m, particularly preferably from 0.15 to 1.0 $\mu$m.

Optionally, the coating may further contain additional ingredients such as surfactants, especially perfluoro surfactants, silicon or titanium dioxide particles, organic or inorganic spacer particles or matting agents.

Any coating method can be used for applying two or more coating solutions to the hydrophilic surface of the support. The multi-layer coating can be applied by coating/drying each layer consecutively or by the simultaneous coating of several coating solutions at once. In the drying step, the volatile solvents are removed from the coating until the coating is self-supporting and dry to the touch. However it is not necessary (and may not even be possible) to remove all the solvent in the drying step. Indeed the residual solvent content may be regarded as an additional composition variable by means of which the composition may be optimized. Drying is typically carried out by blowing hot air onto the coating, typically at a temperature of at least 70°C, suitably 80-150°C and especially 90-140°C. Also infrared lamps can be used. The drying time may typically be 15-600 seconds.

Between coating and drying, or after the drying step, a heat treatment and subsequent cooling may provide additional benefits, as described in WO99/21715, EP-A 1074386, EP-A 1074889, WO00/29214, and WO/04030923, WO/04030924, WO/04030925.

## Examples

The pH change caused by cross-contamination between the developing solution and the rinsing and/or gumming solution which may occur during processing, has been simulated by a titration reaction. Then, the amount of replenishment i.e. fresh rinsing solution, required to obtain the start pH was quantified by a back titration reaction.

This test gives an idea of how much replenishment solution would be required during processing to maintain the pH of the rinse solution substantially constant.

1. Rinsing solutions RS1 to RS4

The composition of the rinsing solutions RS1 to RS4 are given in Table 1.

Table 1: rinsing solutions

| | RS1 | RS2* | RS3* | RS4* |
|---|---|---|---|---|
| Rinsing solution | Demineralized water | Certipur buffer pH 4 | Certipur buffer pH 7 | Certipur buffer pH 10 |
| pH** | 7.25 | 4.06 | 7.06 | 9.98 |
| *Commercially available form Merck;<br>**Measured with a ProfiLine pH/Cond 3320 commercially available from WTW. | | | | |

2. Titration reaction

In a first step, 1 ml of THD300 developer was added stepwise (per 0.1 ml) to 50ml of the different rinsing/gumming solutions RS1 to RS4. THD300 developer is commercialy available from Agfa Graphics NV.

The evolution of the pH upon titration of the rinsing solutions with the alkaline developer THD300 is summarised in Table 2.

Table 2: pH evolution upon titration

| THD300* addition | RS1** *Comp Ex* | RS2** *Inv Ex 1* | RS3** *Inv Ex 2* | RS4** *Inv Ex 3* |
|---|---|---|---|---|
| ml | pH | pH | pH | pH |

(continued)

| THD300* addition | RS1** *Comp Ex* | RS2** *Inv Ex 1* | RS3** *Inv Ex 2* | RS4** *Inv Ex 3* |
|---|---|---|---|---|
| 0 | 7.25 | 4.06 | 7.07 | 9.97 |
| 0.1 | 10.71 | 4.10 | 7.10 | 10.01 |
| 0.2 | 11.04 | 4.12 | 7.14 | 10.07 |
| 0.3 | 11.25 | 4.17 | 7.16 | 10.14 |
| 0.4 | 11.35 | 4.19 | 7.19 | 10.23 |
| 0.5 | 11.47 | 4.22 | 7.21 | 10.33 |
| 0.6 | 11.54 | 4.26 | 7.25 | 10.51 |
| 0.7 | 11.61 | 4.28 | 7.27 | 10.65 |
| 0.8 | 11.67 | 4.32 | 7.31 | 10.78 |
| 0.9 | 11.7 | 4.35 | 7.34 | 10.98 |
| 1.0 | 11.75 | 4.37 | 7.37 | 11.17 |
| * Developer commercially available from Agfa Graphics;<br>**Rinsing solutions ; see Table 1. | | | | |

The results in Table 2 show that the pH increase of the comparative solution RS1 is substantially higher compared to the pH increase of the inventive solutions RS2 to RS4.

3. Back titration

The amount of fresh rinse solution required to adjust the pH of the solutions obtained after adding 1 ml of developer THD300 to the initial pH was determined (see Table 3).

Table 3: Back titration

| | RS1 + 1 ml | RS2 + 1 ml | RS3 + 1 ml | RS4 + 1 ml |
|---|---|---|---|---|
| | THD300 *Comp 1* | THD300 *Inv 1* | THD300 *Inv 2* | THD300 *Inv 3* |
| Start pH of the solution | 11.75 | 4.37 | 7.37 | 11.17 |
| End pH of the solution | 7.25 | 4.06 | 7.06 | 9.98 |
| Added solution RS1 ml | 10.000 | - | - | - |
| Added solution RS2 ml | - | 3.500 | - | - |
| Added solution RS3 ml | - | - | 750 | - |
| Added solution RS4 ml | - | - | - | 3.500 |

The results in Table 3 show that a much higher amount of replenishing solution - i.e. fresh rinse solution - is required to adjust the pH of the rinse liquid RS1 to the initial pH compared to the rinse solutions RS2 to RS4.

The results indicate that the amount of replenishment solution - i.e. fresh rinse solution - that is required to maintain the pH of the rinse liquid constant during the processing step of the plate material, is much higher for a rinse solution including only water compared to a rinse solution including a buffer. In other words, the bath live of a rinse solution based on water only, is substantially lower than the bath life of the rinse solutions including a buffer.

## Claims

**1.** A method for processing a heat-sensitive lithographic printing plate material comprising the steps of:

(i) treating the plate material with an alkaline development solution,

(ii) rinsing the plate material with an aqueous solution,
(iii) treating the plate material with a gum solution;

**characterized in that** the aqueous solution contains a buffer.

2. A method according to claim 1 wherein the heat-sensitive plate material is positive-working and includes on a support having a hydrophilic surface or which is provided with a hydrophilic layer, a coating including an oleophilic and/or an acetale binder, and an infrared absorbing agent.

3. A method according to any of any of the preceding claims wherein the plate material comprises a heat-sensitive positive-working coating on a support, wherein the coating comprises

- an first layer comprising an oleophilic resin and/or a vinyl acetal (co-)polymer, and
- a second layer between the image recording layer and the support, wherein the second layer comprises at least one polymer which includes a sulfonamide group, an imide group, a nitrile group, a urethane group, a urea group, a carboxyl group, a sulfonic acid group and/or a phosphoric acid group.

4. A method according to any of the preceding claims wherein the aqueous solution essentially consists of a buffer and water.

5. A method according to any of the preceding claims wherein the buffer maintains the pH of the aqueous solution in a range of 0 to 10.

6. A method according to any of the preceding claims wherein the buffer maintains the pH of the aqueous solution in a range of 0.5 to 7.

7. A method according to any of the preceding claims wherein the buffer is a mixtures containing acetic acid, citric acid, oxalic acid, tartaric acid, benzoic acid, molybdic acid, boric acid, nitric acid, sulfuric acid, diethyl barbituric acid, phosphoric acid or polyphosphoric acid, and their water soluble alkali metal salts or ammonium salts.

8. A method according to any of the preceding claims wherein the gum solution has a pH from 0 to 8.

9. A method according to any of the preceding claims wherein the gum solution has a pH from 1 to 6.

10. A method according to any of the preceding claims wherein the pH of the aqueous solution ≤ the pH of the gum solution.

11. A method according to any of the preceding claims wherein the gum solution includes one or more surface protective compounds which, after step (iii), remains on the plate as a layer comprising 0.05 to 20 g/m2 of said surface protective compound.

12. A method according to any of the preceding claims wherein step (iii) involves treating the plate material with a first gum solution and consecutively with a second gum solution which are configured as a cascade and whereby the second gum solution overflows into the first gum solution.

13. A method according to any of the preceding claims wherein the alkaline development solution has a pH of at least 10.

14. A method according to any of the preceding claims wherein the alkaline development solution is substantially free of silicates.

## Patentansprüche

1. Ein Verfahren zur Verarbeitung eines wärmeempfindlichen lithografischen Druckplattenmaterials, das die folgenden Schritte umfasst:

(i) Behandlung des Plattenmaterials mit einer alkalischen Entwicklungslösung,
(ii) Spülung des Plattenmaterials mit einer wässrigen Lösung,
(iii) Behandlung des Plattenmaterials mit einer Gummierlösung,

**dadurch gekennzeichnet, dass** die wässrige Lösung einen Puffer enthält.

2. Ein Verfahren nach Anspruch 1, wobei das wärmeempfindliche Plattenmaterial positiv arbeitend ist und auf einem Träger mit einer hydrophilen Oberfläche oder einem mit einer hydrophilen Schicht versehenen Träger eine Beschichtung, die ein oleophiles Bindemittel und/oder ein Acetalbindemittel und ein Infrarotlicht absorbierendes Mittel enthält, umfasst.

3. Ein Verfahren nach einem der vorstehenden Ansprüche, wobei das Plattenmaterial eine wärmeempfindliche, positiv arbeitende Beschichtung auf einem Träger umfasst, wobei die Beschichtung Folgendes umfasst:

   - eine erste Schicht, die ein oleophiles Harz und/oder ein Vinylacetal(co)polymer enthält, und
   - eine zweite Schicht zwischen der Bildaufzeichnungsschicht und dem Träger, wobei die zweite Schicht mindestens ein Polymer, das eine Sulfonamidgruppe, eine Imidgruppe, eine Nitrilgruppe, eine Urethangruppe, eine Harnstoffgruppe, eine Carboxylgruppe, eine Sulfonsäuregruppe und/oder eine Phosphorsäuregruppe enthält, umfasst.

4. Ein Verfahren nach einem der vorstehenden Ansprüche, wobei die wässrige Lösung im Wesentlichen aus einem Puffer und Wasser besteht.

5. Ein Verfahren nach einem der vorstehenden Ansprüche, wobei der Puffer den pH-Wert der wässrigen Lösung in einem Bereich zwischen 0 und 10 hält.

6. Ein Verfahren nach einem der vorstehenden Ansprüche, wobei der Puffer den pH-Wert der wässrigen Lösung in einem Bereich zwischen 0,5 und 7 hält.

7. Ein Verfahren nach einem der vorstehenden Ansprüche, wobei der Puffer eine Mischung ist, die Essigsäure, Zitronensäure, Oxalsäure, Weinsäure, Benzoesäure, Molybdänsäure, Borsäure, Salpetersäure, Schwefelsäure, Diethylbarbitursäure, Phosphorsäure oder Polyphosphorsäure und deren wasserlösliche Alkalimetallsalze oder Ammoniumsalze enthält.

8. Ein Verfahren nach einem der vorstehenden Ansprüche, wobei die Gummierlösung einen pH-Wert zwischen 0 und 8 aufweist.

9. Ein Verfahren nach einem der vorstehenden Ansprüche, wobei die Gummierlösung einen pH-Wert zwischen 1 und 6 aufweist.

10. Ein Verfahren nach einem der vorstehenden Ansprüche, wobei der pH-Wert der wässrigen Lösung $<$ dem pH-Wert der Gummierlösung liegt.

11. Ein Verfahren nach einem der vorstehenden Ansprüche, wobei die Gummierlösung eine oder mehrere oberflächenschützende Verbindungen enthält, die anschließend an Schritt (iii) als Schicht, die 0,05 bis 20 $g/m^2$ der oberflächenschützenden Verbindung enthält, auf der Platte zurückbleiben.

12. Ein Verfahren nach einem der vorstehenden Ansprüche, wobei im Schritt (iii) das Plattenmaterial mit einer ersten Gummierlösung und anschließend mit einer zweiten Gummierlösung, die kaskadenweise konfiguriert sind, wobei die zweite Gummierlösung in die erste Gummierlösung überfließt, behandelt wird.

13. Ein Verfahren nach einem der vorstehenden Ansprüche, wobei die alkalische Entwicklungslösung einen pH-Wert von mindestens 10 aufweist.

14. Ein Verfahren nach einem der vorstehenden Ansprüche, wobei die alkalische Entwicklungslösung im Wesentlichen silikatfrei ist.

## Revendications

1. Procédé pour le traitement d'un matériau de plaque d'impression lithographique thermosensible comprenant les étapes consistant à:

(i) traiter le matériau de plaque avec une solution révélatrice alcaline,
(ii) rincer le matériau de plaque avec une solution aqueuse,
(iii) traiter le matériau de plaque avec une solution de gommage,

**caractérisé en ce que** la solution aqueuse contient un tampon.

**2.** Procédé selon la revendication 1, **caractérisé en ce que** le matériau de plaque thermosensible est un matériau à effet positif et comprend, sur un support ayant une surface hydrophile ou un support revêtu d'une couche hydrophile, un revêtement contenant un liant oléophile et/ou un liant d'acétal et un agent absorbant les rayons infrarouges.

**3.** Procédé selon l'une quelconque des revendications précédentes, **caractérisé en ce que** le matériau de plaque comprend un revêtement thermosensible à effet positif sur un support, ledit revêtement comprenant:

- une première couche contenant une résine oléophile et/ou un (co)polymère de vinylacétal, et
- une deuxième couche entre la couche d'enregistrement d'image et le support, où la deuxième couche comprend au moins un polymère contenant un groupe sulfonamide, un groupe imide, un groupe nitrile, un groupe uréthane, un groupe urée, un groupe carboxylique, un groupe acide sulfonique et/ou un groupe acide phosphorique.

**4.** Procédé selon l'une quelconque des revendications précédentes, **caractérisé en ce que** la solution aqueuse se compose essentiellement d'un tampon et d'eau.

**5.** Procédé selon l'une quelconque des revendications précédentes, **caractérisé en ce que** le tampon maintient la valeur de pH de la solution aqueuse dans un intervalle allant de 0 à 10.

**6.** Procédé selon l'une quelconque des revendications précédentes, **caractérisé en ce que** le tampon maintient la valeur de pH de la solution aqueuse dans un intervalle allant de 0,5 à 7.

**7.** Procédé selon l'une quelconque des revendications précédentes, **caractérisé en ce que** le tampon est un mélange contenant de l'acide acétique, de l'acide citrique, de l'acide oxalique, de l'acide tartrique, de l'acide benzoïque, de l'acide molybdique, de l'acide borique, de l'acide nitrique, de l'acide sulfurique, de l'acide diéthylbarbiturique, de l'acide phosphorique ou de l'acide polyphosphorique et des sels de métaux alcalins ou sels d'ammonium solubles dans l'eau de ceux-ci.

**8.** Procédé selon l'une quelconque des revendications précédentes, **caractérisé en ce que** la solution de gommage présente une valeur de pH comprise entre 0 et 8.

**9.** Procédé selon l'une quelconque des revendications précédentes, **caractérisé en ce que** la solution de gommage présente une valeur de pH comprise entre 1 et 6.

**10.** Procédé selon l'une quelconque des revendications précédentes, **caractérisé en ce que** la valeur de pH de la solution aqueuse est $\leq$ la valeur de pH de la solution de gommage.

**11.** Procédé selon l'une quelconque des revendications précédentes, **caractérisé en ce que** la solution de gommage contient un ou plusieurs composés protecteurs de surface qui, après l'étape (iii), restent sur la plaque sous forme de couche contenant de 0,05 à 20 $g/m^2$ du composé protecteur de surface.

**12.** Procédé selon l'une quelconque des revendications précédentes, **caractérisé en ce que**, lors de l'étape (iii), le matériau de plaque est traité avec une première solution de gommage et ensuite avec une deuxième solution de gommage qui sont configurées en cascade dans laquelle la deuxième solution de gommage déborde dans la première solution de gommage.

**13.** Procédé selon l'une quelconque des revendications précédentes, **caractérisé en ce que** la solution révélatrice alcaline présente une valeur de pH d'au moins 10.

**14.** Procédé selon l'une quelconque des revendications précédentes, **caractérisé en ce que** la solution révélatrice alcaline ne contient essentiellement pas de silicates.

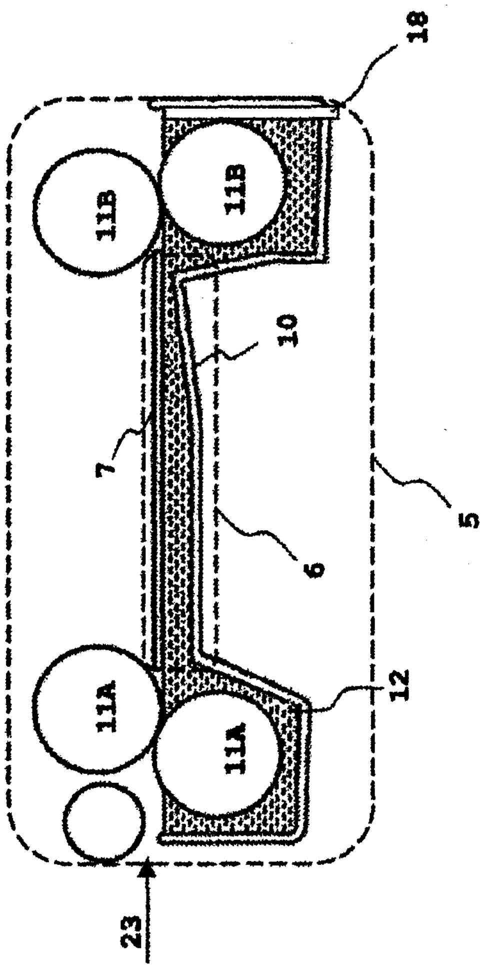


Fig. 1

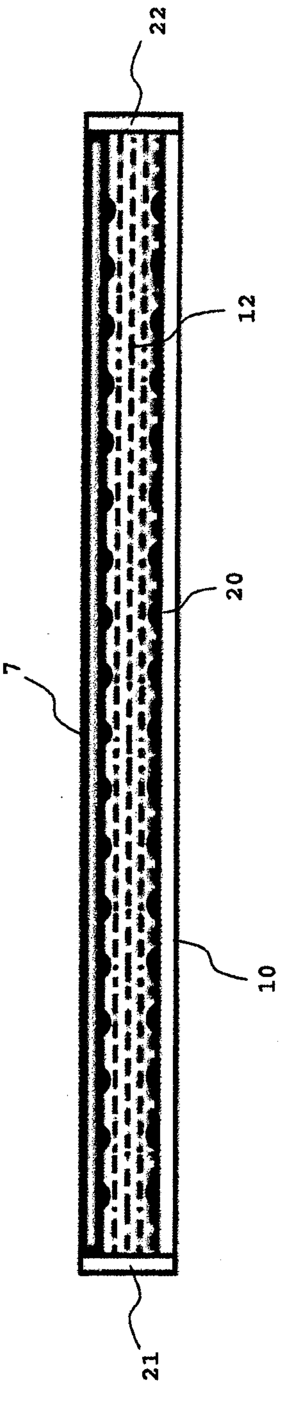


Fig. 2a

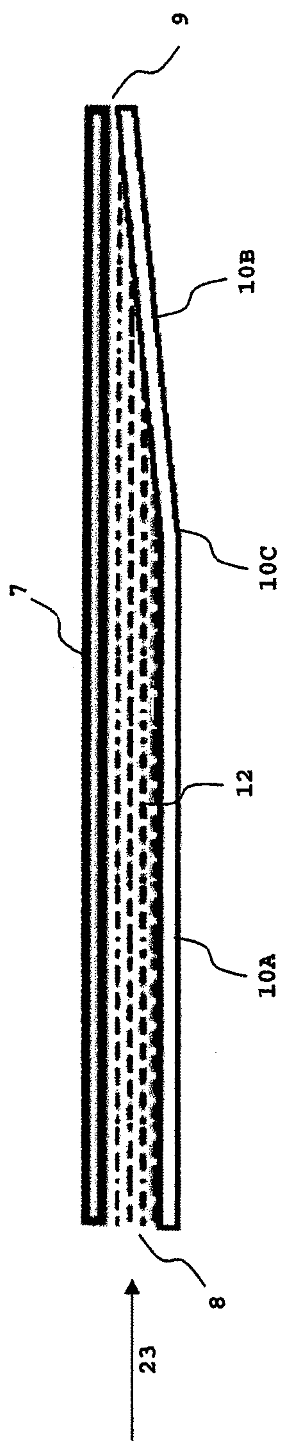


Fig. 2b

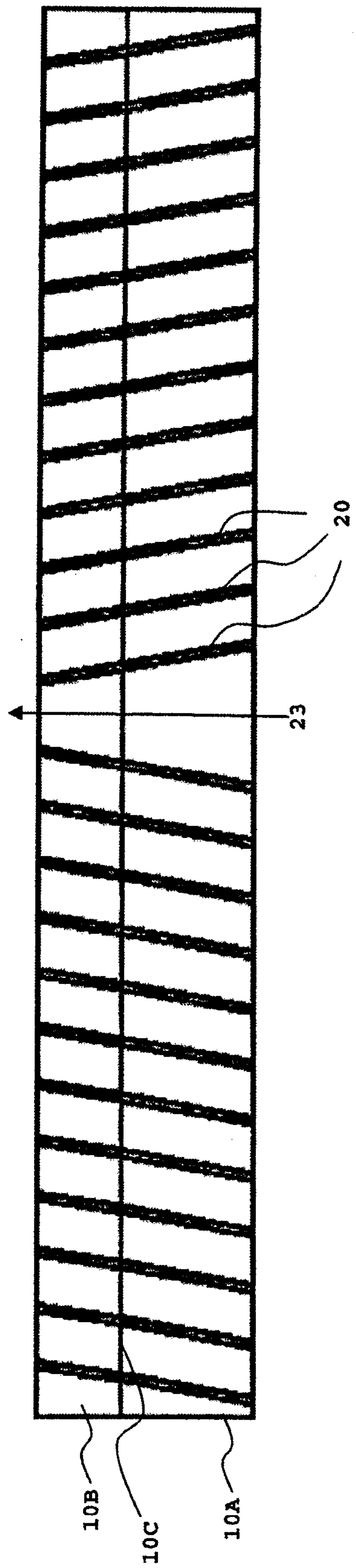


Fig. 3a

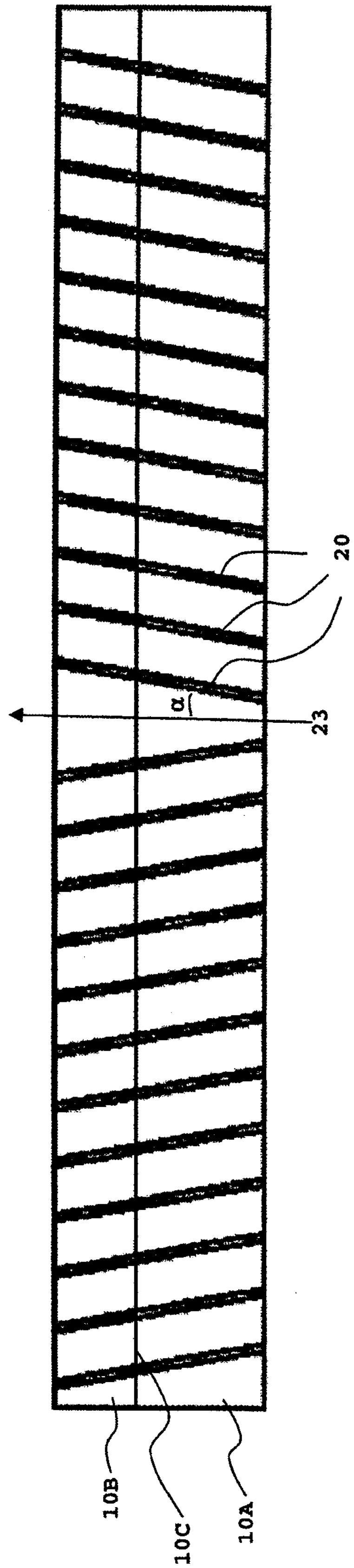


Fig. 3b

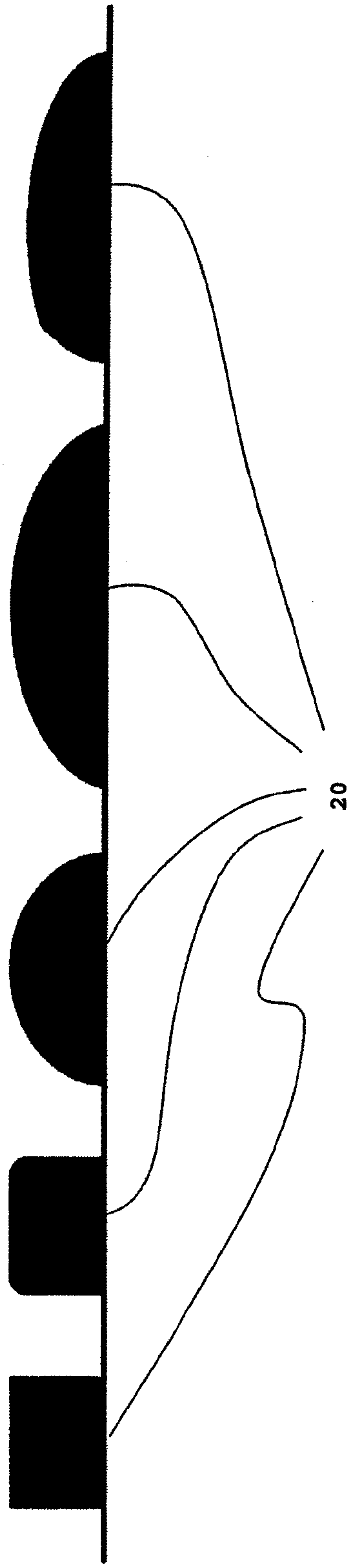


Fig. 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 1524113 A
- EP 1696274 A
- EP 2775351 A
- EP 770494 A
- EP 770495 A
- EP 770497 A
- EP 773112 A
- EP 774364 A
- EP 849090 A
- EP 1614538 A
- EP 1614539 A
- EP 1614540 A
- EP 1777067 A
- EP 1767349 A
- WO 2006037716 A
- WO 2006133741 A
- WO 2007045515 A
- WO 200704551 A
- EP 339393 A
- EP 507008 A
- EP 771645 A
- EP 960729 A
- EP 960730 A
- EP 1267211 A
- DE 4007428 A
- DE 4027301 A
- DE 4445820 A
- EP 0934822 A
- EP 1072432 A
- US 5641608 A
- EP 0982123 A
- WO 9901795 A
- EP 02102446 A
- EP 02102444 A
- EP 02102445 A
- EP 02102443 A
- EP 03102522 A
- US 5262270 A
- US 5169897 A
- US 5534381 A
- US 6458511 B
- US 6541181 B
- US 6087066 A
- US 6270938 B
- WO 20019682 A
- EP 1162209 A
- US 6596460 B
- US 6458503 B
- US 6783913 B
- US 6818378 B
- US 6596456 B
- WO 200273315 A
- WO 200296961 A
- WO 200379113 A
- WO 200420484 A
- WO 200481662 A
- EP 1627732 A
- WO 200717162 A
- WO 2008103258 A
- US 6255033 B
- WO 20095582 A
- WO 200985093 A
- WO 200109682 A
- US 20094599 B
- WO 200999518 A
- US 2006130689 A
- US 2003166750 A
- US 5330877 A
- US 200481662 B
- US 20053296 B
- WO 20073030 A
- US 20090291387 A
- US 201047723 B
- US 20110059399 A
- WO 2014106554 A
- WO 2015158566 A
- WO 2015173231 A
- WO 2015189092 A
- WO 2016001023 A
- EP 2159049 A
- US 6573022 B
- EP 90968 A
- WO 0196119 A
- EP 2497639 A
- EP 1262318 A
- EP 1275498 A
- EP 909657 A
- EP 1120246 A
- EP 894622 A
- US 5141838 A
- EP 1545878 A
- EP 1400351 A
- EP 933682 A
- EP 982123 A
- WO 9963407 A
- EP 2047988 A
- EP 901902 A
- US 20050214677 A

- US 4115128 A
- JP 60088942 A
- JP 2096755 A
- EP 823327 A
- WO 9739894 A
- EP 825927 A
- EP 864420 A
- EP 950517 A
- WO 9921725 A
- WO 0145958 A
- EP 978376 A
- EP 1029667 A
- EP 1053868 A
- EP 1093934 A
- WO 0029214 A
- EP 400706 A
- WO 2006005688 A
- WO 9921715 A
- EP 1074386 A
- EP 1074889 A
- WO 04030923 A
- WO 04030924 A
- WO 04030925 A
- EP 1029668 A2
- US 3635709 A
- JP 55076346 A
- JP SHO50117503 A
- JP SHO50113305 A
- US 3859099 A
- US 3759711 A
- GB 739654 A
- US 4266001 A
- JP 55057841 A
- DE P1214086
- US 5955238 A
- US 6037098 A
- US 5629354 A
- US 6232038 B
- US 6218076 B
- US 6010824 A
- DE 1470154
- EP 024629 A
- EP 107792 A
- US 4410621 A
- EP 215453 A
- DE 3211312
- EP 1091247 A
- EP 11614541 A
- EP 1349006 A
- WO 2005109103 A
- EP 1788448 A
- EP 1788435 A
- EP 1788443 A
- EP 1788434 A
- US 20040260050 A
- US 20050003285 A
- US 20050123853 A
- EP 1369232 A
- EP 1369231 A
- EP 1341040 A
- US 20030124460 A
- EP 1241002 A
- EP 1288720 A
- US 6027857 A
- US 6171735 B
- US 6420089 B
- EP 152819 A
- EP 1043 A
- EP 627 A
- US 6899994 B
- US 20050170286 A

**Non-patent literature cited in the description**

- CRC Handbook of Chemistry and Physics. 1986
- Industrial Sprays and Atomization. Springer, 17 September 2002
- Handbook of Atomization and Sprays. Springer, 2011